# EUROPEAN PATENT APPLICATION

(11) **EP 4 719 014 A1**
(43) Date of publication of application: **01.04.2026**
(21) Application number: 25205461.4
(22) Date of filing: 29.09.2025
(51) Int. Cl.: H10K 59/122, H10K 59/131, H10K 59/35, H10K 59/80

(54) **ELECTRONIC DEVICE**

(30) Priority: 30.09.2024 KR 20240132536; 04.12.2024 KR 20240178184
(71) Applicant: Samsung Display Co., Ltd., Yongin-si, Gyeonggi-do 17113 (KR)
(72) Inventor: LEE, Sungeun, 17113 Yongin-si (KR); KANG, Ki Nyeng, 17113 Yongin-si (KR); KWON, Dohyun, 17113 Yongin-si (KR); KIM, Sikwang, 17113 Yongin-si (KR); KIM, Hyoeng-Ki, 17113 Yongin-si (KR); NAM, Yunyong, 17113 Yongin-si (KR); MOON, Junhwan, 17113 Yongin-si (KR); PARK, Jonghee, 17113 Yongin-si (KR); PARK, Chanju, 17113 Yongin-si (KR); BAEK, Jongjun, 17113 Yongin-si (KR); LEE, Kyoungwon, 17113 Yongin-si (KR); LEE, Jaehun, 17113 Yongin-si (KR)
(74) Representative: Taor, Simon Edward William

(57) **Abstract**

An electronic device includes a substrate including a non-emission area including a normal area and support areas surrounded by the normal area, a pixel defining layer in which opening portions overlapping emission areas in a plan view are defined, light emitting elements, each of which includes a first electrode, a common layer disposed on the first electrode, and a second electrode disposed on the common layer, a partition wall disposed on the pixel defining layer and overlapping the normal area in a plan view, and spacers disposed on the pixel defining layer and overlapping the support areas in a plan view. Each of the spacers is surrounded by the partition wall adjacent to the spacer and is spaced apart from the partition wall.

## Description

### CROSS-REFERENCE TO RELATED APPLICATION(S)

This application claims priority to and benefits of Korean Patent Application Nos. 10-2024-0132536, filed on September 30, 2024, and 10-2024-0178184, filed on December 04, 2024.

### BACKGROUND

### 1. Technical Field

The disclosure relates to an electronic device with improved display quality.

### 2. Description of the Related Art

In general, electronic equipment such as smartphones, digital cameras, notebook computers, navigation devices and smart televisions, which provide images for users, include electronic devices for displaying images. An electronic device generates an image and provides a user with the generated image through a display screen.

An electronic device includes multiple pixels for generating the image, and multiple lines connected to the pixels. The pixels are driven by receiving driving signals through the lines.

In middle and large-sized electronic devices such as tablet computers or smart televisions having larger surface areas, a difference between driving voltages respectively transmitted to pixels may occur, and a design to compensate for this difference is required.

### SUMMARY

The disclosure provides an electronic device capable of providing a uniform driving voltage to pixels.

The disclosure also provides an electronic device in which a spacer is disposed in a display area during a process using a mask to maintain a tip structure of a partition wall.

An electronic device according to an embodiment of the disclosure may include a substrate including a display area which includes emission areas and a non-emission area including a normal area and support areas, surrounded by the normal area, and disposed between the emission areas, an interlayer insulating layer disposed on the substrate, a pixel defining layer which is disposed on the interlayer insulating layer and in which opening portions overlapping the emission areas in a plan view are defined, light emitting elements, each of which includes a first electrode disposed on the interlayer insulating layer and overlapping each of the opening portions in a plan view, a common layer disposed on the first electrode, and a second electrode disposed on the common layer, a partition wall disposed on the pixel defining layer and overlapping the normal area in a plan view, and spacers disposed on the pixel defining layer and overlapping the support areas in a plan view. Each of the spacers may be surrounded by the partition wall adjacent to the each of the spacers and may be spaced apart from the partition wall.

A height from the pixel defining layer to the spacers may be greater than a height from the pixel defining layer to the partition wall.

The spacers may include a transparent organic material or a colored organic material having a light blocking property.

Each of the spacers may include a first pattern disposed on the pixel defining layer, and a second pattern disposed on the first pattern.

In an area adjacent to the support areas, a height of the pixel defining layer overlapping the spacers in a plan view may be greater than a height of the pixel defining layer overlapping the partition wall in a plan view.

A surface area in which the support areas are disposed in the display area may be in a range of about 1% to about 10% of an entire surface area of the display area.

The partition wall may include a first insulating pattern disposed on the pixel defining layer, a second insulating pattern disposed on the first insulating pattern, a third insulating pattern disposed on the second insulating pattern, a first partition wall pattern disposed on the third insulating pattern, and a second partition wall pattern disposed on the first partition wall pattern.

The first to third insulating patterns may include different materials. The first insulating pattern may include at least one of indium zinc oxide, indium gallium zinc oxide, and indium tin oxide, and the second insulating pattern and the third insulating pattern may include one of silicon oxide, silicon oxynitride, and silicon nitride.

The first partition wall pattern may include aluminum, and the second partition wall pattern may include titanium.

A thickness of the first partition wall pattern may be greater than a thickness of the second partition wall pattern, a width of the second partition wall pattern may be greater than a width of the first partition wall pattern, and a portion of a bottom surface of the second partition wall pattern may protrude from the first partition wall pattern to be exposed from the first partition wall pattern, and form a tip portion.

The second electrode may be a single pattern provided, in common, to the light emitting elements, and the second electrode may extend from the emission areas to the non-emission area and cover a side surface of the first partition wall pattern and the portion of the bottom surface of the second partition wall pattern.

The electronic device may further include a dummy pattern disposed between the second partition wall pattern and the second electrode, and the dummy pattern and the common layer may include a same material.

The electronic device may further include power lines that provide power to the light emitting elements, overlap the display area in a plan view, and are disposed between the interlayer insulating layer and the substrate.

The non-emission area may further include contact areas surrounded by the normal area in a plan view and spaced apart from the support areas, contact holes which pass through the interlayer insulating layer and the pixel defining layer and expose the power lines may be defined in the contact areas, and the first partition wall pattern may be in contact with the power lines exposed by the contact holes.

In the contact areas, at least one of the first to third insulating patterns may cover a side surface of the pixel defining layer and a side surface of the interlayer insulating layer, which define the contact holes.

The pixel defining layer may include a colored organic material having a light blocking property.

The electronic device may further include an encapsulation layer that covers the light emitting elements and is disposed on the pixel defining layer. The encapsulation layer may include inorganic layers and an organic layer disposed between the inorganic layers.

The emission areas may include a first-first emission area and a first-second emission area which provide light of a first color and are spaced apart from each other in the first direction, a second emission area which provides light of a second color different from the first color and is spaced apart from the first-first emission area and a first-second emission area in a diagonal direction, and a third emission area which is spaced apart from the second emission area in a second direction intersecting the first direction and provides light of a third color different from the first and second colors.

Each of the spacers may be disposed between the first-first emission area, a first-second emission area, a second emission area, and the third emission area adjacent to the each of the spacers.

The first-first emission area, a first-second emission area, a second emission area, and third emission area may have different shapes in a plan view.

According to an aspect, there is provided an electronic device as set out in claim 1. Additional features are set out in claims 2 to 15.

### BRIEF DESCRIPTION OF THE DRAWINGS

FIG. 1A is a perspective view of an electronic device according to an embodiment of the disclosure.
FIG. 1B is a schematic block diagram of an electronic device according to an embodiment of the disclosure.
FIG. 2 is a schematic cross-sectional view of an electronic device according to an embodiment of the disclosure.
FIG. 3 is a schematic cross-sectional view of a display panel according to an embodiment of the disclosure.
FIG. 4A is a schematic block diagram of a display module according to an embodiment of the disclosure.
FIG. 4B is a schematic diagram of an equivalent circuit of one of pixels illustrated in FIG. 4A.
FIG. 5A is a plan view of a pixel unit according to an embodiment of the disclosure.
FIG. 5B is a schematic plan view illustrating a portion of a display area according to an embodiment of the disclosure.
FIG. 6 is a schematic cross-sectional view taken along line I-I' in FIG. 5A.
FIG. 7 is a schematic enlarged cross-sectional view of a partition wall illustrated in FIG. 6.
FIG. 8 is a schematic cross-sectional view taken along line II-II' in FIG. 5A.
FIG. 9 is a schematic cross-sectional view taken along line III-III' in FIG. 5A.
FIG. 10 is a schematic cross-sectional view of a support area of an electronic device according to an embodiment of the disclosure.
FIG. 11 is a schematic cross-sectional view of a support area of an electronic device according to an embodiment of the disclosure.
FIG. 12 is an enlarged plan view of a display area according to an embodiment of the disclosure.

### DETAILED DESCRIPTION OF THE EMBODIMENTS

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Also, when an element is referred to as being "in contact" or "contacted" or the like to another element, the element may be in "electrical contact" or in "physical contact" with another element; or in "indirect contact" or in "direct contact" with another element.

Like reference symbols refer to like elements throughout. In the drawings, the thickness, ratio, and size of the elements are exaggerated for effectively describing the technical contents.

In the specification and the claims, the phrase "at least one of" is intended to include the meaning of "at least one selected from the group of" for the purpose of its meaning and interpretation. For example, "at least one of A and B" may be understood to mean "A, B, or A and B." In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

It will be understood that, although the terms such as first and second may be used herein to describe various elements, the elements are not to be limited by these terms. These terms are only used to distinguish one element from another element. For instance, a first element could be termed a second element without departing from the scope of the disclosure. Similarly, a second element could be termed a first element. The singular expressions are intended to include the plural forms as well, unless the context clearly indicates otherwise.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The term "about" may include variations of, for example, ±20%, ±10%, or ±5%, from the specified numerical value unless otherwise expressly stated. In some contexts, the term may account for rounding, inherent measurement limitations, or standard tolerances recognized in the relevant technical field. When applied to dimensions, concentrations, or other quantifiable parameters, "about" may include minor deviations that would be understood by a person of ordinary skill in the art as insubstantial in the given context. The scope of "about" should be interpreted in view of standard experimental or clinical tolerances applicable to the field of use. A person skilled in the art would recognize that "about" allows for practical deviations that do not materially alter the intended properties of the invention. Similarly, for mechanical dimensions, "about" may include deviations that are within industry-accepted tolerances and do not materially impact the performance of the disclosure.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the disclosure will be described with reference to the accompanying drawings.

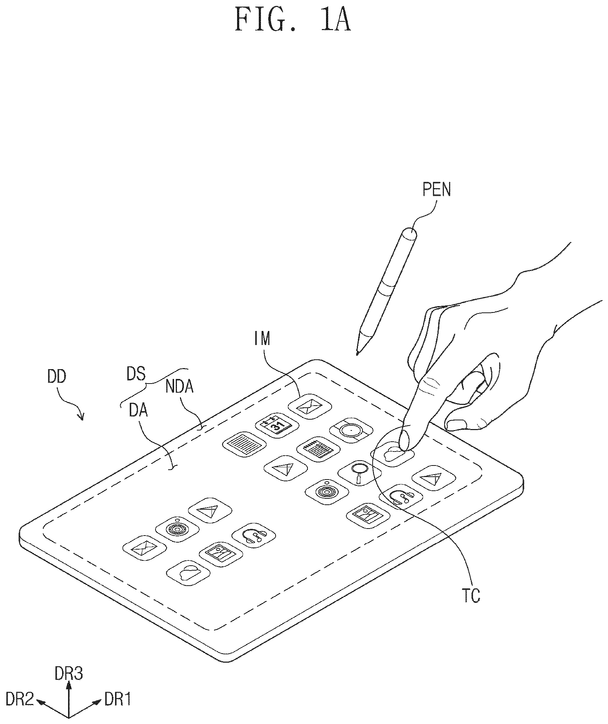

FIG. 1A is a perspective view of an electronic device according to an embodiment of the disclosure. Referring to FIG. 1A, an electronic device DD according to an embodiment of the disclosure may have long sides extending to be parallel to a first direction DR1 and short sides extending to be parallel to a second direction DR2 intersecting the first direction DR1. Corners of the electronic device DD, which connect the long sides to the short sides, may have curve shapes. The corners of the electronic device DD, which have curved shapes, may be defined as round corners. This shape of the electronic device DD may be defined as a round corner rectangle in a plan view. However, this is just one example of the shape of the electronic device DD, and the shape of the electronic device DD is not limited to the round corner rectangle.

Hereinafter, a direction substantially perpendicularly crossing a plane defined by the first direction DR1 and the second direction DR2 may be defined as a third direction DR3. In this specification, the meaning of when viewed on a plane or in a plan view is defined as being in a state when viewed in the third direction DR3.

A front surface of the electronic device DD may be defined as a display surface DS, and may have a plane defined by the first direction DR1 and the second direction DR2. Images IM generated in the electronic device DD may be provided for a user through the display surface DS.

The display surface DS may include a display area DA and a non-display area NDA adjacent to the display area DA. The display area DA may display an image, and the non-display area NDA may not display an image. The non-display area NDA may surround the display area DA, and define an edge of the electronic device DD, which is printed in a certain color.

The display area DA may have a round corner rectangular shape according to the shape of the electronic device DD. For example, the display area DA may include sides of a rectangle extending in the first direction DR1 and the second direction DR2, and rounded corners which connect the sides. The sides, which extend in the first direction DR1, of the four sides may be defined as long sides, and the sides, which extend in the second direction DR2, of the four sides may be defined as short sides.

The electronic device DD may detect inputs applied from the outside of the electronic device DD. For example, the electronic device DD may detect a first input by a touch pen PEN and a second input by a touch TC. The touch pen PEN may be an input device.

The touch pen PEN may be an active pen which outputs a signal. The second input by the touch TC may include various types of external inputs such as part of a user's body, light, heat, or pressure.

The electronic device DD and the touch pen PEN may bidirectionally communicate with each other. The electronic device DD may provide an uplink signal to the touch pen PEN. For example, the uplink signal may include panel information and information on a protocol version or the like, but is not particularly limited thereto.

The touch pen PEN may provide a downlink signal to the electronic device DD. The downlink signal may include a synchronization signal or state information of the touch pen PEN. For example, the downlink signal may include coordinate information of the touch pen PEN, battery information of the touch pen PEN, tilting information of the touch pen PEN, and/or various information stored in the touch pen PEN, but is not particularly limited thereto.

The electronic device DD may be used for large-sized electronic devices such as televisions, monitors, or outdoor billboards. The electronic device DD may be also used for a small and medium-sized electronic devices such as personal computers, notebook computers, personal digital assistants, vehicle navigation devices, game consoles, smartphones, tablet computers, or cameras. However, embodiments of the disclosure are not limited thereto, and the electronic device DD may be used for other electronic apparatuses unless departing from the disclosure.

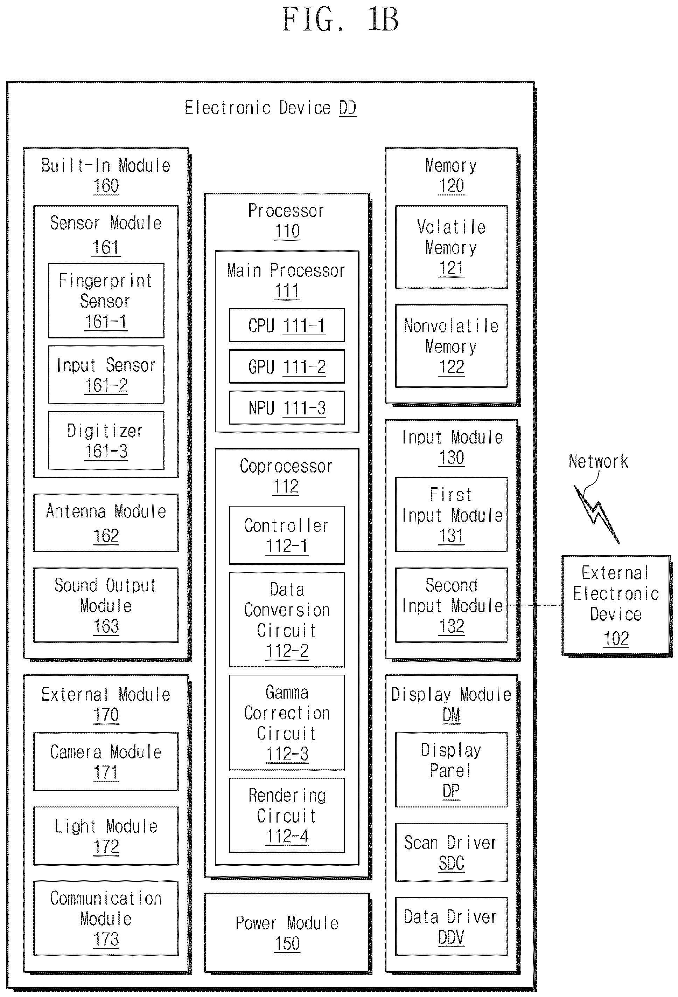

FIG. 1B is a schematic block diagram of an electronic device DD according to an embodiment. Referring to FIG. 1B, the electronic device DD may output various information through a display module DM in an operating system. In case that a processor 110 executes an application stored in a memory 120, the display module DM may provide application information for a user through a display panel DP.

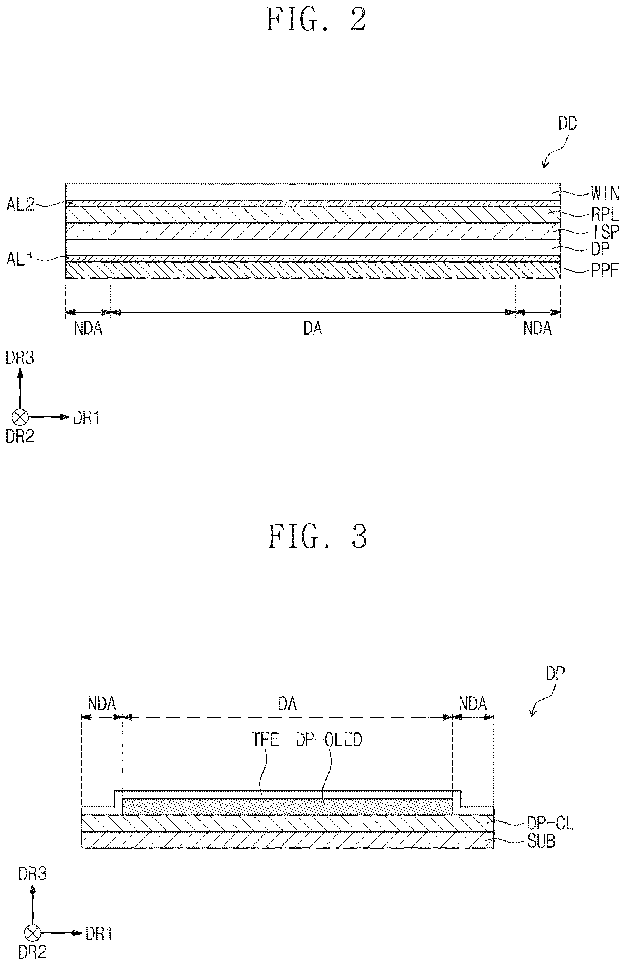

The processor 110 may obtain an external input through an input module 130 or a sensor module 161, and execute an application corresponding to the external input. For example, in case that the user selects a camera icon displayed on the display panel DP, the processor 110 may obtain a user input through an input sensor 161-2 (or an input sensor ISP (see Fig. 2)) and activate a camera module 171. The processor 110 may transmit, to the display module DM, image data corresponding to a photographic image obtained through the camera module 171. The display module DM may display an image corresponding to the photographic image through the display panel DP.

For example, in case that individual information authentication is performed in the display module DM, a fingerprint sensor 161-1 may obtain fingerprint information input as input data. The processor 110 may compare the input data obtained through the fingerprint sensor 161-1 with authentication data stored in the memory 120, and execute an application according to a result of the comparison. The display module DM may display, through the display panel DP, information executed according to a logic of the application.

For example, in case that a music streaming icon displayed on the display module DM is selected, the processor 110 may obtain a user input through the input sensor 161-2 and activate a music streaming application stored in the memory 120. In case that a music play command is input to the music streaming application, the processor 110 may activate a sound output module 163 and provide the user with sound information corresponding to the music play command.

In the above, the operations of the electronic device DD are briefly described. Hereinafter, components of the electronic device DD will be described in detail. Among components of the electronic device DD which will be described below, some components may be integrally provided as one component, and one component may be provided as divided into two or more components.

Referring to FIG. 1B, the electronic device DD may communicate with an external electronic device 102 over a network (e.g., a short-range wireless communication network or a long-range wireless communication network). According to an embodiment, the electronic device DD may include the processor 110, the memory 120, the input module 130, the display module DM, a power module 150, a built-in module 160, and an external module 170. According to an embodiment, in the electronic device DD, at least one of the foregoing components may be omitted, or one or more other components may be added. According to an embodiment, some components (e.g., the sensor module 161, an antenna module 162, or the sound output module 163) of the foregoing components may be integrated into another component (e.g., the display module DM).

The processor 110 may execute software to control at least one other component (e.g., a hardware or software component) of the electronic device DD connected to the processor 110, and may perform various data processing or computation. According to an embodiment, as at least a part of the data processing or computation, the processor 110 may store a command or data received from other component (e.g., the input module 130, the sensor module 161, or a communication module 173) in a volatile memory 121, process the command or data stored in the volatile memory 121, and store the resulting data in a nonvolatile memory 122.

The processor 110 may include a main processor 110 and a coprocessor 112. The main processor 110 may include at least one of a central processing unit (CPU) 111-1 and an application processor (AP). The main processor 110 may further include at least one of a graphic processing unit (GPU) 111-2, a communication processor (CP), and an image signal processor (ISP). The main processor 110 may further include a neural processing unit (NPU) 111-3. The neural processing unit 111-3 may be a processor specialized for processing of an artificial intelligence model, and the artificial intelligence model may be created through machine learning. The artificial intelligence model may include multiple artificial neural network layers. The artificial neural network may include at least one of deep neural network (DNN), convolutional neural network (CNN), recurrent neural network (RNN), restricted Boltzmann machine (RBM), deep belief network (DBN), bidirectional recurrent deep neural network (BRDNN), deep Q-networks, and a combination thereof, but embodiments of the disclosure are not limited thereto. Additionally or alternatively, the artificial intelligence model may include a software structure in addition to a hardware structure. At least two of the foregoing processing units and processors may be implemented as one integrated component (e.g., a single chip), or the foregoing processing units and processors may be implemented as independent components (e.g., multiple chips).

The coprocessor 112 may include a controller 112-1. The controller 112-1 may include an interface conversion circuit and a timing control circuit. The controller 112-1 may receive an image signal from the main processor 110 and output image data obtained by converting a data format of the image signal suitable for the specification of an interface with the display module DM. The controller 112-1 may output various control signals for driving the display module DM.

The coprocessor 112 may further include a data conversion circuit 112-2, a gamma correction circuit 112-3, a rendering circuit 112-4, or the like. The data conversion circuit 112-2 may receive image data from the controller 112-1, and compensate the image data such that an image is displayed with a desired luminance according to a characteristic of the electronic device DD or user settings, or convert the image data to reduce power consumption or compensate for image-sticking. The gamma correction circuit 112-3 may convert image data, a gamma reference voltage, or the like such that an image displayed on the electronic device DD has a desired gamma characteristic. The rendering circuit 112-4 may receive the image data from the controller 112-1, and render the image data in consideration of a pixel arrangement of the display panel DP applied to the electronic device DD, or the like. At least one of the data conversion circuit 112-2, the gamma correction circuit 112-3, and the rendering circuit 112-4 may be integrated into other component (e.g., the main processor 110 or the controller 112-1). At least one of the data conversion circuit 112-2, the gamma correction circuit 112-3, and the rendering circuit 112-4 may be integrated into a data driver DDV to be described later.

The memory 120 may store various data used by at least one component (e.g., the processor 110 or the sensor module 161) of the electronic device DD, and input data or output data for relevant commands. The memory 120 may include at least one of the volatile memory 121 and the nonvolatile memory 122.

The input module 130 may receive a command or data to be used in a component (e.g., the processor 110, the sensor module 161, or the sound output module 163) of the electronic device DD from the outside (e.g., the user or the external electronic device 102) of the electronic device DD.

The input module 130 may include a first input module 131 to which a command or data is input from the user, and a second input module 132 to which a command or data is input from the external electronic device 102. The first input module 131 may include a microphone, a mouse, a keyboard, a key (e.g., a button), or a pen (e.g., a passive pen or an active pen). The second input module 132 may support a designated protocol capable of being connected to the external electronic device 102 in a wired or wireless manner. According to an embodiment, the second input module 132 may include a high definition multimedia interface (HDMI), a universal serial bus (USB) interface, a secure digital (SD) card interface, or an audio interface. The second input module 132 may include a connector capable of being physically connected to the external electronic device 102, for example, an HDMI connector, a USB connector, an SD card connector, or an audio connector (e.g., a headphone connector).

The display module DM may visually provide information for the user. The display module DM may include the display panel DP, a scan driver SDC and the data driver DDV. The display module DM may further include a window, a chassis, and a bracket for protecting the display panel DP.

The display panel DP may include a liquid crystal display panel, an organic light emitting display panel, or an inorganic light emitting display panel, and the type of the display panel DP is not particularly limited. The display panel DP may be a rigid type, or a flexible type capable of rolling or folding. The display module DM may further include a supporter which supports the display panel DP, a bracket, a heat dissipation member, or the like.

The scan driver SDC may be mounted as a driving chip on the display panel DP. In another embodiment, the scan driver SDC may be integrated into the display panel DP. For example, the scan driver SDC may include an amorphous silicon TFT gate driver circuit (ASG), a low temperature polycrystalline silicon (LTPS) TFT gate driver circuit, or an oxide semiconductor TFT gate driver circuit (OSG), internalized into the display panel DP. The scan driver SDC may receive a control signal from the controller 112-1, and output scan signals to the display panel DP in response to the control signal.

The display panel DP may further include a light emission driver (not illustrated). The light emission driver may output an emission control signal to the display panel DP in response to the control signal received from the controller 112-1. The light emission driver may be separated from the scan driver SDC, or be integrated into the scan driver SDC.

The data driver DDV may receive the control signal from the controller 112-1, and convert image data into analog voltages (e.g., data voltages) in response to the control signal and output the data voltages to the display panel DP.

The data driver DDV may be incorporated into other component (e.g., the controller 112-1). The functions of the interface conversion circuit and the timing control circuit of the controller 112-1, described above, may be incorporated into the data driver DDV.

The display module DM may further include the light emission driver, a voltage generation circuit, and the like. The voltage generating circuit may output various voltages for driving the display panel DP.

The power module 150 may supply power to the components of the electronic device DD. The power module 150 may include a battery which charges a power voltage. The battery may include a non-rechargeable primary battery, a rechargeable secondary battery, or a fuel cell battery. The power module 150 may include a power management integrated circuit (PMIC). The PMIC may supply optimized power to each of the modules described above and modules to be described below. The power module 150 may include a wireless power transmission/reception member electrically connected to the battery. The wireless power transmission/reception member may include multiple antenna radiators in the form of coils.

The electronic device DD may further include the built-in module 160 and the external module 170. The built-in module 160 may include the sensor module 161, the antenna module 162, and the sound output module 163. The external module 170 may include the camera module 171, a light module 172, and the communication module 173.

The sensor module 161 may detect an input by the user's body or an input by a pen of the first input module 131, and generate an electrical signal or data value corresponding to the input. The sensor module 161 may include at least one of the fingerprint sensor 161-1, the input sensor 161-2, and a digitizer 161-3.

The fingerprint sensor 161-1 may generate a data value corresponding to the user's fingerprint. The fingerprint sensor 161-1 may include one of an optical sensor or a capacitance fingerprint sensor.

The input sensor 161-2 may generate a data value corresponding to coordinate information of an input by the user's body or an input by a pen. The input sensor 161-2 may generate a capacitance change due to the input as a data value. The input sensor 161-2 may detect an input by the passive pen or transmit/receive data to/from the active pen.

The input sensor 161-2 may measure a bio-signal such as blood pressure, moisture, or body fat. For example, in case that the user touches a part of the body to a sensor layer or a sensing panel and does not move for a certain period of time, the input sensor 161-2 may detect a bio-signal and output information desired by the user to the display module DM on the basis of a change in electric field caused by the part of the body.

The digitizer 161-3 may generate a data value corresponding to coordinate information of an input by the pen. The digitizer 161-3 may generate an electromagnetic change by the input as a data value. The digitizer 161-3 may detect an input by the passive pen or transmit/receive data to/from the active pen.

At least one of the fingerprint sensor 161-1, the input sensor 161-2, and the digitizer 161-3 may be implemented in a sensor layer formed on the display panel DP through a continuous process. The fingerprint sensor 161-1, the input sensor 161-2, and the digitizer 161-3 may be disposed above the display panel DP, and one of the fingerprint sensor 161-1, the input sensor 161-2, and the digitizer 161-3, for example, the digitizer 161-3, may be disposed below the display panel DP.

At least two of the fingerprint sensor 161-1, the input sensor 161-2, and the digitizer 161-3 may be integrated into one sensing panel through a same process. In case that at least two of the fingerprint sensor 161-1, the input sensor 161-2, and the digitizer 161-3 are integrated into one sensing panel, the sensing panel may be disposed between the display panel DP and a window disposed above the display panel DP. According to an embodiment, the sensing panel may be disposed on the window, but the position of the sensing panel is not particularly limited.

At least one of the fingerprint sensor 161-1, the input sensor 161-2, and the digitizer 161-3 may be built in the display panel DP. For example, at least one of the fingerprint sensor 161-1, the input sensor 161-2, and the digitizer 161-3 may be simultaneously formed through a process of forming elements (e.g., light emitting elements, transistors, or the like) included in the display panel DP.

The sensor module 161 may generate an electrical signal or data value corresponding to an internal state or external state of the electronic device DD. The sensor module 161 may further include, for example, a gesture sensor, a gyro sensor, a barometric pressure sensor, a magnetic sensor, an acceleration sensor, a grip sensor, a proximity sensor, a color sensor, an IR (infrared) sensor, a biosensor, a temperature sensor, a humidity sensor, or an illuminance sensor.

The antenna module 162 may include one or more antennas for transmitting a signal or power to the outside or receiving a signal or power from the outside. According to an embodiment, the communication module 173 may transmit a signal to an external electronic device 102 or receive a signal from the external electronic device 102 through an antenna suitable for a communication method. An antenna pattern of the antenna module 162 may be integrated into one component (e.g., the display panel DP) of the display module DM, the input sensor 161-2, or the like.

The sound output module 163 may be a device for outputting a sound signal to the outside of the electronic device DD, and include, for example, a speaker used for general purposes such as multimedia playback or recording playback and a receiver used exclusively for receiving calls. According to an embodiment, the receiver may be provided integrally with or separately from the speaker. A sound output pattern of the sound output module 163 may be integrated into the display module DM.

The camera module 171 may photograph still images and moving images. According to an embodiment, the camera module 171 may include one or more lenses, image sensors, or image signal processors. The camera module 171 may further include an infrared camera capable of measuring the presence/absence of a user, the user's position, the user's gaze, or the like.

The light module 172 may provide light. The light module 172 may include a light emitting diode or a xenon lamp. The light module 172 may operate in conjunction with the camera module 171 or operate independently.

The communication module 173 may establish a wired or wireless communication channel between the electronic device DD and the external electronic device 102, and support communication through the established communication channel. The communication module 173 may include at least one of a wireless communication module such as a cellular communication module, a short-range wireless communication module, or a global navigation satellite system (GNSS) communication module, and a wired communication module such as a local area network (LAN) communication module or a power line communication module. The communication module 173 may communicate with the external electronic device 102 through a short-range communication network such as Bluetooth, WiFi direct, or infrared data association (IrDA), or a long-range communication network such as cellular network, Internet, or computer network (e.g., LAN or WAN). The foregoing various types of communication modules 173 may be implemented as a single chip, or implemented as separate chips, respectively.

The input module 130, the sensor module 161, the camera module 171, and the like may be utilized to control the operation of the display module DM in conjunction with the processor 110.

The processor 1100 may output a command or data to the display module DM, the sound output module 163, the camera module 171, or the light module 172, based on input data received from the input module 130. For example, the processor 110 may generate image data in response to the input data input through a mouse, an active pen, or the like, and output the image data to the display module DM, or may generate command data in response to the input data and output the command data to the camera module 171 or the light module 172. In case that the input data is not received from the input module 130 for a certain period of time, the processor 110 may convert an operation mode of the electronic device DD into a low power mode or a sleep mode, thereby reducing power consumed by the electronic device DD.

The processor 110 may output a command or data to the display module DM, the sound output module 163, the camera module 171, or the light module 172, based on sensing data received from the sensor module 161. For example, the processor 110 may compare authentication data input by the fingerprint sensor 161-1 with authentication data stored in the memory 120 and execute an application according to a result of the comparison. The processor 110 may execute a command, based on sensing data detected by the input sensor 161-2 or the digitizer 161-3, or output corresponding image data to the display module DM. In case that the sensor module 161 includes a temperature sensor, the processor 110 may receive temperature data for temperatures measured from the sensor module 161 and further perform a luminance correction, or the like on the image data, based on the temperature data.

The processor 110 may receive measurement data about the presence/absence of a user, the position of the user, the user's gaze, or the like from the camera module 171. The processor 110 may further perform the luminance correction or the like on the image data, based on the measurement data. For example, the processor 110 having determined the presence/absence of a user through an input from the camera module 171 may output, to the display module DM, image data in which the luminance is corrected through the data conversion circuit 112-2 or the gamma correction circuit 112-3.

Some of the foregoing components may be connected to each other through a communication method between peripheral devices, for example, a bus, a general purpose input/output (GPIO), a serial peripheral interface (SPI), a mobile industry processor interface (MIPI), or a ultra path interconnect (UPI) link, and exchange signals (e.g., commands or data) with each other. The processor 110 may communicate with the display module DM through an appointed interface. For example, any one of the foregoing communication methods may be used, and the communication method is not limited to the foregoing communication methods.

The electronic devices DD according to various embodiments described herein may be various types of devices. The electronic device DD may be, for example, at least one of a portable communication device (e.g., a smartphone), a computer device, a portable multimedia device, a portable medical device, a camera, a wearable device, and a home appliance. The electronic device DD is not limited to the foregoing devices.

FIG. 2 is a schematic cross-sectional view of an electronic device according to an embodiment of the disclosure. For example, FIG. 2 schematically illustrates a cross-section of the electronic device DD viewed in the second direction DR2. Some of the components of the electronic device DD, described with reference to FIG. 1B, are omitted in FIG. 2.

Referring to FIG. 2, the electronic device DD may include a display panel DP, an input sensor ISP, an anti-reflective layer RPL, a window WIN, a panel protective film PPF, and first and second adhesive layers AL1 and AL2. The input sensor ISP illustrated in FIG. 2 may be the same component as the input sensor 161-2 described with reference to FIG. 1B.

The display panel DP according to an embodiment of the disclosure may be an emissive display panel. For example, the display panel DP may be an organic light emitting display panel or an inorganic light emitting display panel. An emission layer of the organic light emitting display panel may include an organic light emitting material. An emission layer of the inorganic light emitting display panel may include a quantum dot, a quantum rod, and the like. Hereinafter, the display panel DP is described as an organic light emitting display panel.

The input sensor ISP may be disposed on the display panel DP. The input sensor ISP may include multiple sensing parts (not illustrated) for sensing an external input by using a capacitance method. The input sensor ISP may be directly manufactured on the display panel DP during manufacture of the electronic device DD. Thus, the input sensor ISP according to an embodiment may be directly disposed on the display panel DP. However, the input sensor ISP is not limited thereto, and may be manufactured as a separate panel from the display panel DP and attached to the display panel DP through an adhesive layer.

The anti-reflective layer RPL may be disposed on the input sensor ISP. The anti-reflective layer RPL may be directly manufactured on the input sensor ISP during the manufacture of the electronic device DD. However, the anti-reflective layer RPL is not limited thereto, and may be manufactured as a separate panel and attached to the input sensor ISP through an adhesive layer.

The anti-reflective layer RPL may be a film that prevents the reflection of external light. The anti-reflective layer RPL may reduce the reflectance of external light incident from above the electronic device DD toward the display panel DP. The external light may not be visible to a user due to the anti-reflective layer RPL.

In case that external light traveling toward the display panel DP is reflected by the display panel DP and provided for an external user again, the external light may be visible to the user like a mirror. To prevent this phenomenon, the anti-reflective layer RPL may include, for example, multiple color filters that display same colors as pixels of the display panel DP.

The color filters may filter the external light to have same colors as the pixels, and the external light may not be visible to the user. However, the anti-reflective layer RPL is not limited thereto, and may include a retarder and/or a polarizer in order to reduce the reflectance of the external light.

The window WIN may be disposed on the anti-reflective layer RPL. The window WIN may protect the display panel DP, the input sensor ISP, and the anti-reflective layer RPL from external scratch and impact.

The panel protective film PPF may be disposed below the display panel DP. The panel protective film PPF may protect a lower portion of the display panel DP. The panel protective film PPF may include a flexible plastic material such as polyethylene terephthalate (PET).

The first adhesive layer AL1 may be disposed between the display panel DP and the panel protective film PPF, and the display panel DP and The panel protective film film PPF may be bonded to each other through the first adhesive layer AL1. The second adhesive layer AL2 may be disposed between the window WIN and the anti-reflective layer RPL, and the window WIN and the anti-reflective layer RPL may be bonded to each other through the second adhesive layer AL2.

FIG. 3 is a schematic cross-sectional view of a display panel according to an embodiment of the disclosure. For example, FIG. 3 schematically illustrates a cross-section of a display panel DP viewed in the second direction DR2.

Referring to FIG. 3, the display panel DP may include a substrate SUB, a circuit element layer DP-CL disposed on the substrate SUB, a display element layer DP-OLED disposed on the circuit element layer DP-CL, and a thin-film encapsulation layer TFE disposed on the display element layer DP-OLED.

The substrate SUB may include a display area DA and a non-display area NDA adjacent to the display area DA. The substrate SUB may include glass, or a flexible plastic material such as polyimide. The display element layer DP-OLED may be disposed in the display area DA.

Multiple pixels may be disposed in the circuit element layer DP-CL and the display element layer DP-OLED. Each of the pixels may include a transistor disposed in the circuit element layer DP-CL, and a light emitting element disposed in the display element layer DP-OLED and connected to the transistor.

The thin-film encapsulation layer TFE may be disposed on the circuit element layer DP-CL and cover the display element layer DP-OLED. The thin-film encapsulation layer TFE may protect the pixels from moisture, oxygen, and external foreign matter. The thin-film encapsulation layer TFE may include inorganic layers and an organic layer. The organic layer may be disposed between the inorganic layers and sealed from the inorganic layers to provide a flat surface. According to an embodiment, the organic layer may be disposed on the inorganic layers or omitted, and embodiments of the disclosure are not limited to any one embodiment.

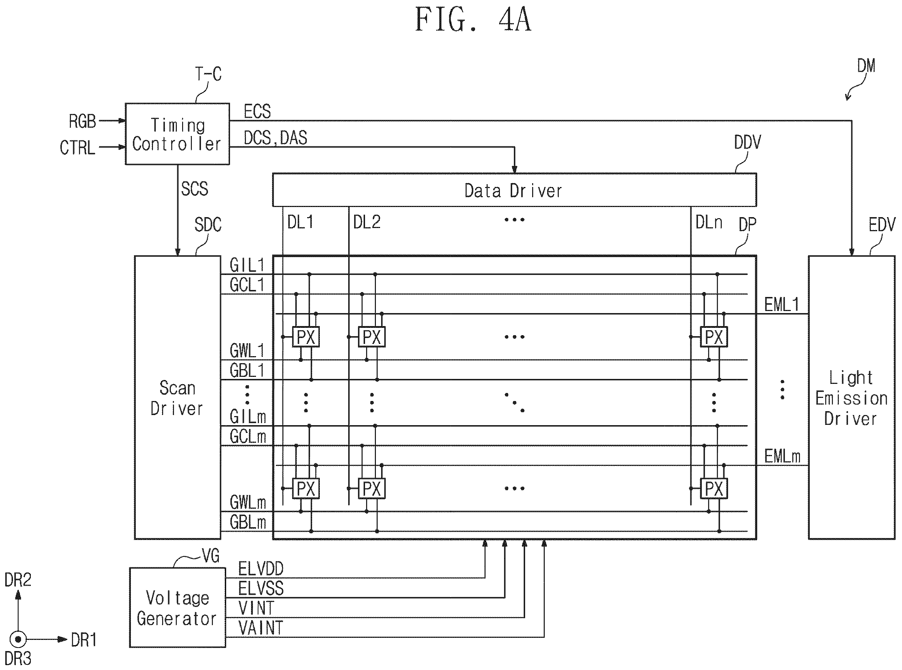

FIG. 4A is a schematic block diagram of a display module according to an embodiment of the disclosure.

Referring to FIG. 4A, a display module DM may include a display panel DP, a timing controller T-C, a scan driver SDC, a data driver DDV, a light emission driver EDV, and a voltage generator VG.

The display panel DP may include multiple scan lines GIL1 to GILm, GCL1 to GCLm, GWL1 to GWLm and GBL1 to GBLm, multiple emission lines EML1 to EMLm, multiple data lines DL1 to DLn, and multiple pixels PX. m and n are each a natural number greater than 1.

Pixels PX may be electrically connected to the scan lines GIL1 to GILm, GCL1 to GCLm, GWL1 to GWLm and GBL1 to GBLm, the emission lines EML1 to EMLm, and the data lines DL1 to DLn, respectively. Each of the pixels PX may be electrically connected to four corresponding scan lines, one corresponding data line, and one corresponding emission line.

The scan lines GIL1 to GILm, GCL1 to GCLm, GWL1 to GWLm and GBL1 to GBLm may include multiple initialization scan lines GIL1 to GILm, multiple compensation scan lines GCL1 to GCLm, multiple write scan lines GWL1 to GWLm, and multiple bias scan lines GBL1 to GBLm.

Each of the pixels PX may be connected to a corresponding one of the initialization scan lines GIL1 to GILm, a corresponding one of the compensation scan lines GCL1 to GCLm, a corresponding one of the write scan lines GWL1 to GWLm, and a corresponding one of the bias scan lines GBL1 to GBLm.

The scan lines GIL1 to GILm, GCL1 to GCLm, GWL1 to GWLm and GBL1 to GBLm may be connected to the scan driver SDC, and extend in the first direction DR1 to be arranged in the second direction DR2. The emission lines EML1 to EMLm may be connected to the light emission driver EDV, and extend in the first direction DR1 to be arranged in the second direction DR2. The data lines DL1 to DLn may be connected to the data driver DDV, and extend in the second direction DR2 to be arranged in the first direction DR1.

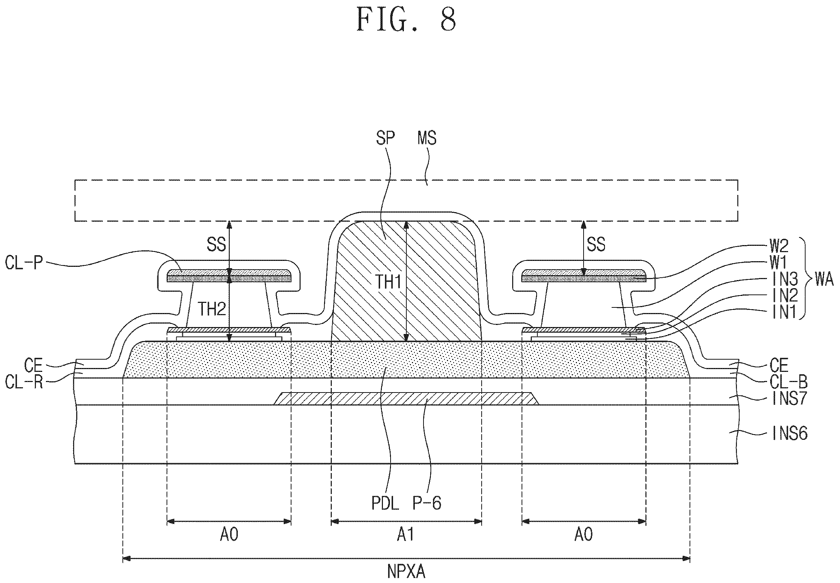

The scan driver SDC, the light emission driver EDV, and the data driver DDV may be substantially disposed on the display panel DP, and this configuration will be illustrated in FIG. 8 below.

The timing controller T-C may receive an image signal RGB and a control signal CTRL. The timing controller T-C may generate an image data signal DAS obtained by converting a data format of the image signal RGB to match an interface specification of the data driver DDV. The timing controller T-C may output a scan control signal SCS, a data control signal DCS, and an emission control signal ECS in response to the control signal CTRL.

The voltage generator VG may generate voltages for an operation of the display panel DP. The voltage generator VG may generate a first driving voltage ELVDD, a second driving voltage ELVSS, a first initialization voltage VINT, and a second initialization voltage VAINT. The first driving voltage ELVDD, the second driving voltage ELVSS, the first initialization voltage VINT, and the second initialization voltage VAINT may be applied to the pixels PX.

The scan driver SDC may receive the scan control signal SCS from the timing controller T-C. The scan driver SDC may output scan signals to the scan lines GIL1 to GILm, GCL1 to GCLm, GWL1 to GWLm and GBL1 to GBLm in response to the scan control signal SCS. The scan signals may be applied to the pixels PX through the scan lines GIL1 to GILm, GCL1 to GCLm, GWL1 to GWLm and GBL1 to GBLm.

The data driver DDV may receive the data control signal DCS and the image data signal DAS from the timing controller T-C. The data driver DDV may convert the image data signal DAS into data signals to output the data signals. The data signals may be defined as analog voltages corresponding to gray levels of the image data signal DAS. The data signals may be applied to the pixels PX through the data lines DL1 to DLn.

The light emission driver EDV may receive an emission control signal ECS from the timing controller T-C. The light emission driver EDV may output emission signals to the emission lines EML1 to EMLm in response to the emission control signal ECS. The emission signals may be applied to the pixels PX through the emission lines EML1 to EMLm.

The pixels PX may receive the data voltages in response to the scan signals. The pixels PX may display an image by emitting light with luminance corresponding to the data voltages in response to the emission signals.

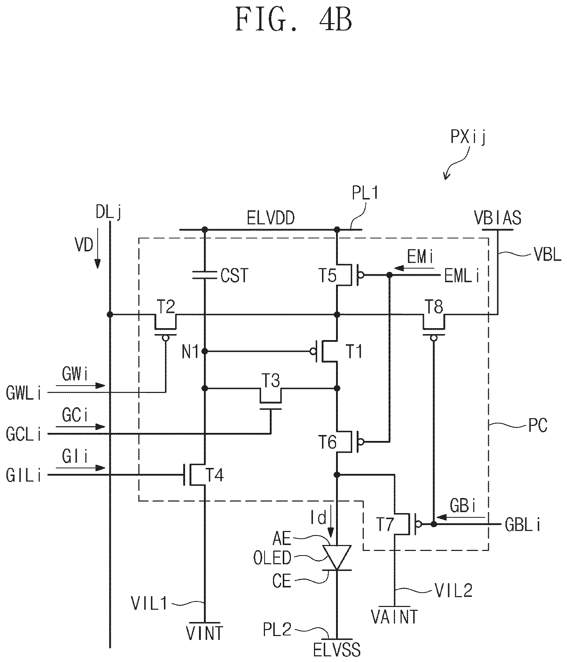

FIG. 4B is a schematic diagram of an equivalent circuit of one of the pixels illustrated in FIG. 4A.

For example, FIG. 4B schematically illustrates a pixel PXij connected to a j-th data line DLj, i-th scan lines GWLi, GCLi, GILi and GBLi, and an i-th emission line EMLi. i and j are each a natural number greater than 0.

Referring to FIG. 4B, the pixel PXij may include a pixel circuit PC and a light emitting element OLED connected to the pixel circuit PC. The pixel circuit PC may drive the light emitting element OLED.

The pixel circuit PC may include multiple transistors T1 to T8 and a capacitor CST. The transistors T1 to T8 and the capacitor CST may control an amount of current Id flowing through the light emitting element OLED. The light emitting element OLED may generate light having a luminance according to an amount of received current Id.

An i-th write scan line GWLi may receive an i-th write scan signal GWi, and an i-th compensation scan line GCLi may receive an i-th compensation scan signal GCi. An i-th initialization scan line GILi may receive an i-th initialization scan signal GIi, and an i-th bias scan line GBLi may receive an i-th bias scan signal GBi. The i-th emission line EMLi may receive an i-th emission signal EMi.

The pixel PXij may be connected to the j-th data line DLj, the i-th write scan line GWLi, the i-th compensation scan line GCLi, the i-th initialization scan line GILi, the i-th bias scan line GBLi, the i-th emission line EMLi, a first initialization line VIL1, a second initialization line VIL2, a bias line VBL, and first and second power lines PL1 and PL2.

The first initialization line VIL1 may receive a first initialization voltage VINT, and the second initialization line VIL2 may receive a second initialization voltage VAINT. The bias line VBL may receive a bias voltage VBIAS. The first power line PL1 may receive a first driving voltage ELVDD, and the second power line PL2 may receive a second driving voltage ELVSS.

Each of the transistors T1 to T8 may include a source electrode, a drain electrode, and a gate electrode. Hereinafter, for the sake of convenience, in FIG. 4B, one of the source electrode and the drain electrode is defined as a first electrode, and another one of the source electrode and the drain electrode is defined as a second electrode. The gate electrode is defined as a control electrode.

The transistors T1 to T8 may include first to eighth transistors T1 to T8. The first, second, and fifth to eighth transistors T1, T2 and T5 to T8 may be PMOS transistors. The third and fourth transistors T3 and T4 may be NMOS transistors.

The first transistor T1 may be defined as a driving transistor, and the second transistor T2 may be defined as a switching transistor. The third transistor T3 may be defined as a compensation transistor. The fourth transistor T4 and the seventh transistor T7 may each be defined as an initialization transistor. The fifth transistor T5 and the sixth transistor T6 may each be defined as an emission control transistor. The eighth transistor T8 may be defined as a bias transistor.

The light emitting element OLED may be an organic light emitting element. The light emitting element OLED may include a first electrode AE and a second electrode CE. The first electrode AE may receive the first driving voltage ELVDD through the sixth, first, and fifth transistors T6, T1 and T5. The first driving voltage ELVDD may be applied to the pixel circuit PC through the first power line PL1.

The second electrode CE may receive the second driving voltage ELVSS having a lower level than the first driving voltage ELVDD. The second driving voltage ELVSS may be applied to the pixel circuit PC through the second power line PL2.

The first transistor T1 may be disposed between the fifth transistor T5 and the sixth transistor T6 and be connected to the fifth transistor T5 and the sixth transistor T6. The first transistor T1 may be connected to the first power line PL1 through the fifth transistor T5 and be connected to the first electrode AE through the sixth transistor T6.

The first transistor T1 may include a first electrode connected to the first power line PL1 through the fifth transistor T5, a second electrode connected to the first electrode AE through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control an amount of current Id flowing through the light emitting element OLED according to a voltage of the first node N1, which is applied to the control electrode of the first transistor T1.

The second transistor T2 may be disposed between the first transistor T1 and the j-th data line DLj, and be connected to the first transistor T1 and the j-th data line DLj. The second transistor T2 may include a first electrode connected to the j-th data line DLj, a second electrode connected to the first electrode of the first transistor T1, and a control electrode connected to the i-th write scan line GWLi.

The second transistor T2 may be turned on in response to the i-th write scan signal GWi received through the i-th write scan line GWLi, and electrically connect the j-th data line DLj to the first electrode of the first transistor T1. The second transistor T2 may perform a switching operation of providing a data voltage VD (corresponding to the data signal described above), received through the j-th data line DLj, to the first electrode of the first transistor T1.

The third transistor T3 may be connected to the first node N1 and the second electrode of the first transistor T1. The third transistor T3 may include a first electrode connected to the second electrode of the first transistor T1, a second electrode connected to the first node N1, and a control electrode connected to the i-th compensation scan line GCLi.

The third transistor T3 may be turned on in response to the i-th compensation scan signal GCi received through the i-th compensation scan line GCLi, and electrically connect the second electrode of the first transistor T1 to the control electrode of the first transistor T1. In case that the third transistor T3 is turned on, the first transistor T1 and the third transistor T3 may be diode-connected.

The fourth transistor T4 may be connected to the first node N1. The fourth transistor T4 may include a first electrode connected to the first node N1, a second electrode connected to the first initialization line VIL1, and a control electrode connected to the i-th initialization scan line GILi. The fourth transistor T4 may be turned on in response to the i-th initialization scan signal GIi received through the i-th initialization scan line GILi, and provide the first initialization voltage VINT, received through the first initialization line VIL1, to the first node N1.

The fifth transistor T5 may include a first electrode connected to the first power line PL1, a second electrode connected to the first electrode of the first transistor T1, and a control electrode connected to the i-th emission line EMLi.

The sixth transistor T6 may include a first electrode connected to the second electrode of the first transistor T1, a second electrode connected to the first electrode AE, and a control electrode connected to the i-th emission line EMLi.

The fifth transistor T5 and the sixth transistor T6 may be turned on in response to the i-th emission signal EMi received through the i-th emission line EMLi. The first driving voltage ELVDD may be provided to the light emitting element OLED by the turned-on fifth transistor T5 and sixth transistor T6 so that driving current Id flows through the light emitting element OLED. Accordingly, the light emitting element OLED may emit light.

The seventh transistor T7 may include a first electrode connected to the first electrode AE, a second electrode connected to the second initialization line VIL2, and a control electrode connected to the i-th bias scan line GBLi. The seventh transistor T7 may be turned on in response to the i-th bias scan signal GBi received through the i-th bias scan line GBLi, and provide the second initialization voltage VAINT, received through the second initialization line VIL2, to the first electrode AE of the light emitting element OLED.

In an embodiment of the disclosure, the second initialization voltage VAINT and the first initialization voltage VINT may have different levels. However, embodiments of the disclosure are not limited thereto, and in another embodiment, the second initialization voltage VAINT and the first initialization voltage VINT may have a same level.

The seventh transistor T7 may improve black display performance of the pixel PXij. In case that the seventh transistor T7 is turned on, a parasitic capacitor (not illustrated) of the light emitting element OLED may be discharged. Thus, in case that a black luminance is implemented, the light emitting element OLED may not emit light due to leakage current from the first transistor T1, and accordingly, the black display performance may be improved.

The capacitor CST may include a first electrode connected to the first power line PL1, and a second electrode connected to the first node N1. In case that the fifth transistor T5 and the sixth transistor T6 are turned on, an amount of current flowing through the first transistor T1 may be determined according to a voltage stored in the capacitor CST.

The eighth transistor T8 may include a first electrode connected to the bias line VBL, a second electrode connected to the first electrode of the first transistor T1, and a control electrode connected to the i-th bias scan line GBLi.

The eighth transistor T8 may be turned on in response to the i-th bias scan signal GBi and provide the bias voltage VBIAS, received through the bias line VBL, to the first electrode of the first transistor T1. However, the transistors included in the pixel PXij are not limited thereto.

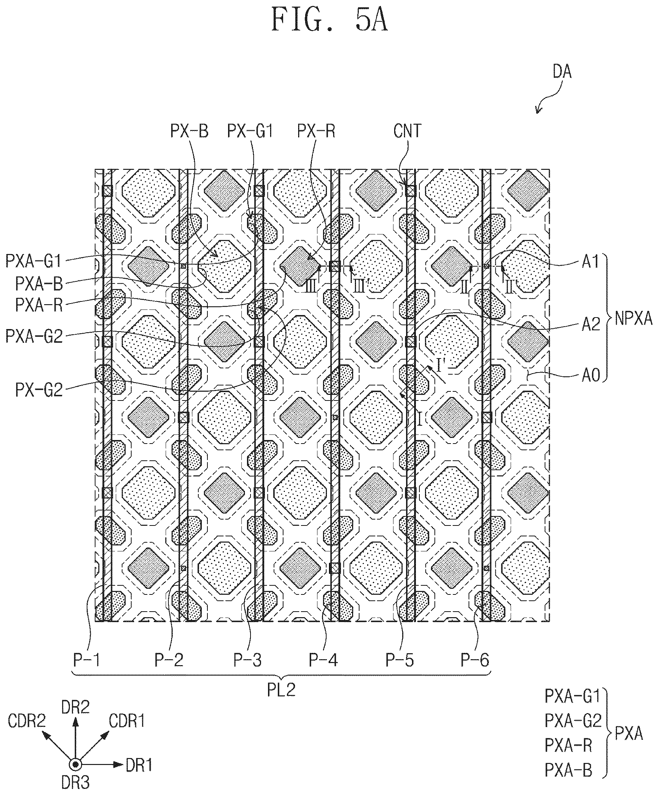

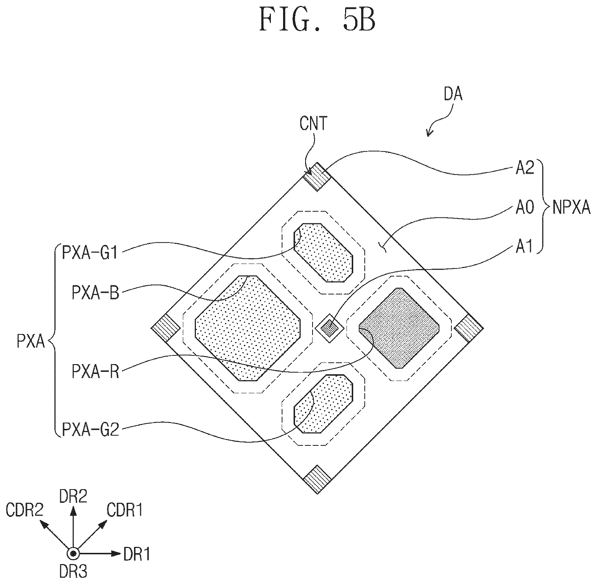

FIG. 5A is a plan view of a pixel unit according to an embodiment of the disclosure. FIG. 5B is a schematic plan view illustrating a portion of a display area according to an embodiment of the disclosure.

Referring to FIG. 5A, in an embodiment, one pixel unit may include the pixels described with reference to FIGS. 4A and 4B. The pixel unit may be provided in plurality, and the pixel units may be arranged in first and second diagonal directions CDR1 and CDR2 in the display area DA described with reference to FIG. 1A.

The pixel unit according to an embodiment may include (1-1)-th to third pixels PX-G1, PX-G2, PX-R and PX-B.

The (1-1)-th pixel PX-G1 may provide green light. The light generated in the (1-1)-th pixel PX-G1 may be provided to the display area DA (see FIG. 1A) through a (1-1)-th emission area (also referred to as first-first emission area) PXA-G1. In an embodiment, the (1-1)-th emission area PXA-G1 may have an octagonal shape extending in the second diagonal direction CDR2 in a plan view.

The (1-2)-th pixel PX-G2 and the (1-1)-th pixel PX-G1 may provide a same green light. The light generated in the (1-2)-th pixel (also referred to as second-second emission area) PX-G2 may be provided to the display area DA (see FIG. 1A) through a (1-2)-th emission area PXA-G2. The (1-2)-th emission area PXA-G2 may be spaced apart from the (1-1)-th emission area PXA-G1 in the second direction DR2. In an embodiment, the (1-2)-th emission area PXA-G2 may have an octagonal shape extending in the first diagonal direction CDR1 in a plan view.

The second pixel PX-R may provide red light. The light generated in the second pixel PX-R may be provided to the display area DA (see FIG. 1A) through a second emission area PXA-R. The second emission area PXA-R may be spaced apart from a third emission area PXA-B in the first direction DR1. The second emission area PXA-R may be spaced apart from the (1-1)-th emission area PXA-G1 in the second diagonal direction CDR2, and be spaced apart from the (1-2)-th emission area PXA-G2 in the first diagonal direction CDR1. In an embodiment, the second emission area PXA-R may have a diamond-shaped octagonal shape in a plan view.

The third pixel PX-B may provide blue light. The light generated in the third pixel PX-B may be provided to the display area DA (see FIG. 1A) through the third emission area PXA-B. The third emission area PXA-B may be spaced apart from the (1-1)-th emission area PXA-G1 in the first diagonal direction CDR1, and be spaced apart from the (1-2)-th emission area PXA-G2 in the second diagonal direction CDR2. In an embodiment, the third emission area PXA-B may have a diamond-shaped octagonal shape in a plan view.

According to an embodiment, a surface area of the second emission area PXA-R may be greater than a surface area of each of the (1-1)-th and (1-2)-th emission areas PXA-G1 and PXA-G2, and be less than a surface area of the third emission area PXA-B in a plan view.

FIG. 5A illustrates dotted lines surrounding each of the emission areas, and the dotted lines surrounding the (1-1)-th to third emission areas PXA-G1, PXA-G2, PXA-R and PXA-B may correspond to first electrodes (anodes) respectively included in the (1-1)-th to third pixels PX-G1, PX-G2, PX-R and PX-B.

An area between the (1-1)-th to third emission areas PXA-G1, PXA-G2, PXA-R and PXA-B may be defined as a non-emission area NPXA.

The non-emission area NPXA according to an embodiment of the disclosure may include a normal area A0, support areas A1, and contact areas A2. The support areas A1 and the contact areas A2 may be surrounded by the normal area A0 in a plan view. The support areas A1 and the contact areas A2 may be adjacent to corners of the emission areas PXA. The support areas A1 and the contact areas A2 may be spaced apart from each other.

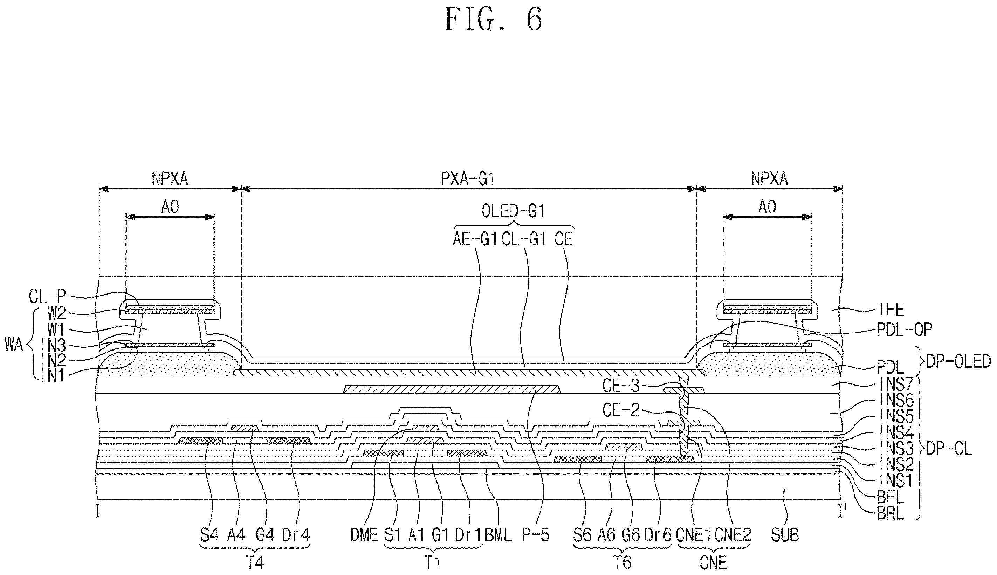

In this specification, the normal area A0 may be defined as an area in which a partition wall WA (see FIG. 6) is disposed on a pixel defining layer PDL (see FIG. 6).

The support areas A1 may each be defined as an area in which a spacer SP (see FIG. 8) to be described below is disposed. The spacer SP may be a structure which supports a mask MS (see FIG. 8). This will be described below.

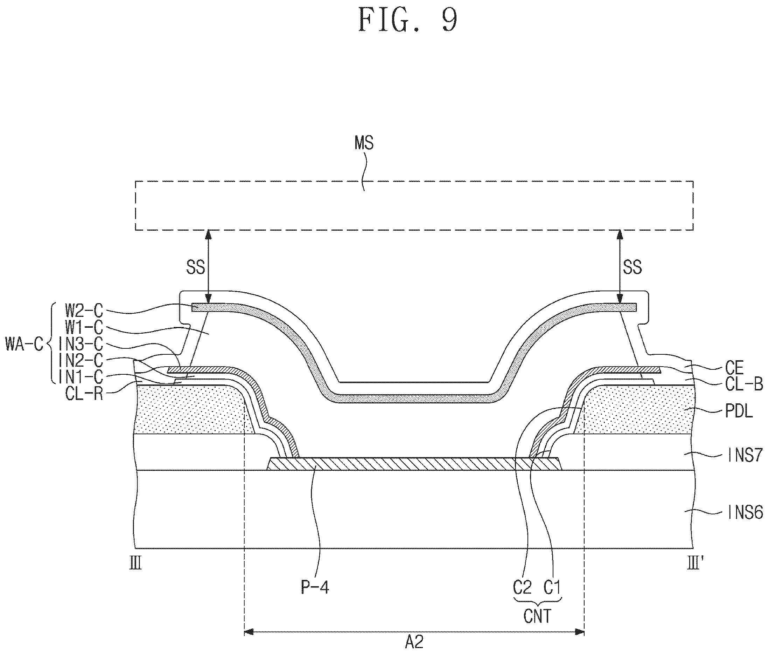

The contact areas A2 may be defined as areas in which contact holes CNT (see FIG. 9) defined in insulating layers and a contact partition wall WA-C (see FIG. 9) are in contact with each other. A second power line PL2 described with reference to FIG. 4A may be connected to a conductive pattern, included in the contact partition wall WA-C (see FIG. 9), through the contact holes CNT (see FIG. 9).

According to an embodiment of the disclosure, the second power line PL2 described with reference to FIG. 4A may be arranged in the display area DA. The second power line PL2 may include lines P-1 to P-6 which are arranged in the first direction DR1 and each extend in the second direction DR2. Each of the lines P-1 to P-6 may overlap at least one contact area A2 and support area A1 in a plan view. Numbers of the contact area A2 and the support area A1 overlapping each of the lines P-1 to P-6 may be different. Each of the lines P-1 to P-6 may be connected to at least one pixel through the contact area A2. This will be described below.

FIG. 5B is a schematic plan view illustrating a display area DA.

Referring to FIG. 5B, an emission area PXA included in one pixel unit may include (1-1)-th to third emission areas PXA-G1, PXA-G2, PXA-R and PXA-B, and a non-emission areas NPXA may include a normal area A0, at least one support area A1, and contact areas A2.

The normal area A0 may occupy most of the non-emission area NPXA, and the support area A1 may be disposed in the normal area A0. For example, one support area A1 may be surrounded by the emission areas PXA-G1, PXA-G2, PXA-R and PXA-B included in the one pixel unit. The contact areas A2 may be disposed outside the emission areas PXA-G1, PXA-G2, PXA-R and PXA-B. For example, the contact areas A2 may be respectively arranged to be adjacent to the outermost corners of the emission areas PXA-G1, PXA-G2, PXA-R and PXA-B. However, embodiments of the disclosure are not limited thereto, and one pixel unit may include at least one support area A1. The spacer SP (see FIG. 8) disposed in the support area A1 may be spaced apart from an adjacent partition wall WA (see FIG. 8). This will be described below.

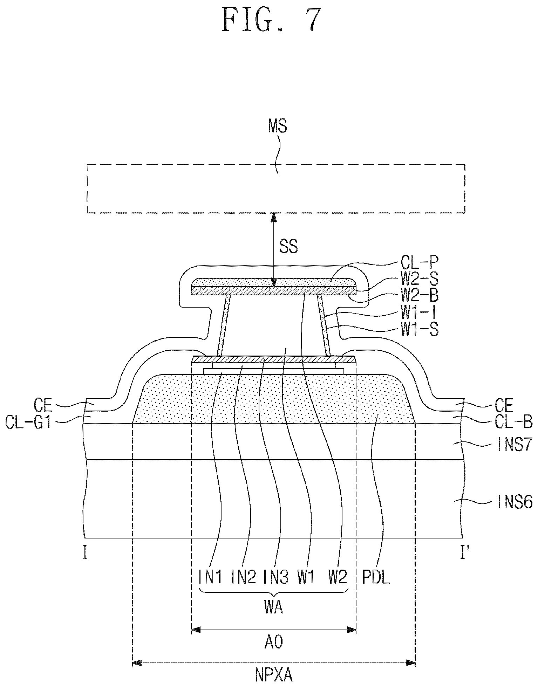

FIG. 6 is a schematic cross-sectional view taken along line I-I' in FIG. 5A. FIG. 7 is a schematic enlarged cross-sectional view of a partition wall illustrated in FIG. 6. FIG. 8 is a schematic cross-sectional view taken along line II-II' in FIG. 5A. FIG. 9 is a schematic cross-sectional view taken along line III-III' in FIG. 5A.

FIG. 6 schematically illustrates a cross-sectional view of a (1-1)-th pixel PX-G1 illustrated in FIG. 5A. Referring to FIG. 6, a light emitting element OLED-G1 according to an embodiment may include a first electrode AE-G1, a second electrode CE, and a common layer CL-G1. The common layer CL-G1 may include a hole control layer, an electron control layer, an emission layer, and the like.

The second electrode CE may be disposed on the first electrode AE-G1, and the common layer CL-G1 may be disposed between the first electrode AE-G1 and the second electrode CE. The light emitting element OLED-G1 according to an embodiment may further include a protective layer (not illustrated) disposed on the second electrode CE. The protective layer may include an organic material, and prevent components disposed below the protective layer from being damaged in a subsequent process. According to another embodiment, the protective layer may be omitted.

First, fourth, and sixth transistors T1, T4 and T6 and the light emitting element OLED-G1 may be disposed on a substrate SUB. The display area DA (see FIG. 1A) may include a (1-1)-th emission area PXA-G1, and a non-emission area NPXA adjacent to the (1-1)-th emission area PXA-G1. FIG. 6 illustrates a partition wall WA disposed in a normal area A0 of the non-emission area NPXA.

The substrate SUB may include glass, or a flexible plastic material such as polyimide. A circuit element layer DP-CL, a display element layer DP-OLED, the partition wall WA, and a thin-film encapsulation layer TFE may be disposed on the substrate SUB. The circuit element layer DP-CL may be disposed on the substrate SUB. The circuit element layer DP-CL may include insulating layers. The display element layer DP-OLED may include the light emitting element OLED-G1 and a pixel defining layer PDL.

A barrier layer BRL may be disposed on the substrate SUB. The barrier layer BRL may increase a bonding force between a semiconductor pattern included in transistors and the substrate SUB. The barrier layer BRL may include an inorganic material.

A metal layer BML may be disposed on the barrier layer BRL. The metal layer BML may overlap the first transistor T1 in a plan view. According to an embodiment, the metal layer BML may receive a constant voltage. In case that a constant voltage is applied to the metal layer BML, a value of a threshold voltage of the first transistor T1 disposed on the metal layer BML may not be changed but maintained.

The metal layer BML may block light incident on the first transistor T1 from below the metal layer BML. The metal layer BML may include a reflective metal. According to another embodiment, the metal layer BML may be omitted.

A buffer layer BFL may be disposed on the barrier layer BRL and cover the metal layer BML. The buffer layer BFL may include an inorganic material.

Semiconductor layers S1, A1 and Dr1 of the first transistor T1 and semiconductor layers S6, A6 and Dr6 of the sixth transistor T6 may be disposed on the buffer layer BFL. The semiconductor layers S1, A1, Dr1, S6, A6 and Dr6 may include polysilicon. However, the semiconductor layers S1, A1, Dr1, S6, A6 and Dr6 are not limited thereto, and may include amorphous silicon.

The semiconductor layers S1, A1, Dr1, S6, A6 and Dr6 may be doped with n-type dopants or p-type dopants. The semiconductor layers S1, A1, Dr1, S6, A6 and Dr6 may include heavy doped regions and light doped regions. The heavy doped regions may have higher conductivity than the light doped regions, and may substantially serve as a source electrode and a drain electrode of each of the first and sixth transistors T1 and T6. The light doped regions may substantially correspond to actives (channels) of the first and sixth transistors T1 and T6.

A first source region S1, a first channel region A1, and a first drain region Dr1 of the first transistor T1 may be provided in the semiconductor layers S1, A1 and Dr1. A sixth source region S6, a sixth channel region A6, and a sixth drain region Dr6 of the sixth transistor T6 may be provided in the semiconductor layers S6, A6 and Dr6. The first channel region A1 may be disposed between the first source region S1 and the first drain region Dr1. The sixth channel region A6 may be disposed between the sixth source region S6 and the sixth drain region Dr6.

A first insulating layer INS1 may be disposed on the buffer layer BFL and cover the semiconductor layers S1, A1, Dr1, S6, A6 and Dr6. A first gate electrode G1 (or a control electrode) of the first transistor T1 and a sixth gate electrode G6 (or a control electrode) of the sixth transistor T6 may be disposed on the first insulating layer INS1. In a plan view, the first gate electrode G1 may overlap the first channel region A1, and the sixth gate electrode G6 may overlap the sixth channel region A6.

Although not illustrated, respective structures of a source region, a channel region, a drain region, and a gate electrode of each of second, fifth, and seventh transistors T2, T5 and T7 may be substantially the same as those of the first and sixth transistors T1 and T6.

A second insulating layer INS2 may be disposed on the first insulating layer INS1 and cover each of the first and sixth gate electrodes G1 and G6. A dummy electrode DME may be disposed on the second insulating layer INS2. The dummy electrode DME may be disposed on the first gate electrode G1, and overlap the first gate electrode G1 in a plan view. The dummy electrode DME and the first gate electrode G1 together may constitute the capacitor described above.

A third insulating layer INS3 may be disposed on the second insulating layer INS2 and cover the dummy electrode DME. Semiconductor layers S4, A4 and Dr4 of the fourth transistor T4 may be disposed on the third insulating layer INS3. The semiconductor layers S4, A4 and Dr4 may include an oxide semiconductor including a metal oxide. The oxide semiconductor may include a crystalline or amorphous oxide semiconductor.

The semiconductor layers S4, A4 and Dr4 may include multiple regions divided according to whether a metal oxide is reduced. A region in which the metal oxide is reduced (hereinafter referred to as a reduction region) may have a higher conductivity than a region in which the metal oxide is not reduced (hereinafter referred to as a non-reduction region). The reduction region may substantially serve as a source electrode or a drain electrode of the fourth transistor T4. The non-reduction region may substantially correspond to an active (or channel) of the fourth transistor T4.

A fourth source region S4, a fourth channel region A4, and a fourth drain region Dr4 of the fourth transistor T4 may be provided in the semiconductor layers S4, A4 and Dr4. The fourth channel region A4 may be disposed between the fourth source region S4 and the fourth drain region Dr4.

A fourth insulating layer INS4 may be disposed on the third insulating layer INS3 and cover the semiconductor layers S4, A4 and Dr4. A fourth gate electrode G4 of the fourth transistor T4 may be disposed on the fourth insulating layer INS4. The fourth gate electrode G4 may overlap the fourth channel region A4 in a plan view.

A fifth insulating layer INS5 may be disposed on the fourth insulating layer INS4 and cover the fourth gate electrode G4. Although not illustrated, respective structures of a source region, a channel region, a drain region, and a gate electrode of a third transistor T3 may be substantially the same as those of the fourth transistor T4.

The barrier layer BRL, the buffer layer BFL, and the first to fifth insulating layers INS1 to INS5 may include an inorganic material. For example, the barrier layer BRL, the buffer layer BFL, and the first to fifth insulating layers INS1 to INS5 may include one of silicon oxide and silicon nitride, or one of the barrier layer BRL, the buffer layer BFL, and the first to fifth insulating layers INS1 to INS5 may include multiple inorganic layers, but embodiments of the disclosure are not limited thereto. The inorganic layers may have a structure in which layers including silicon nitride and silicon oxide are alternately stacked each other.

A connection electrode CNE may be disposed between the sixth transistor T6 and the light emitting element OLED-G1. The connection electrode CNE may electrically connect the sixth transistor T6 to the light emitting element OLED-G1. The connection electrode CNE may include a first connection electrode CNE1, and a second connection electrode CNE2 disposed on the first connection electrode CNE1.

The first connection electrode CNE1 may be disposed on the fifth insulating layer INS5, and connected to the sixth drain region Dr6 through a first contact hole CE-2 defined in the first to fifth insulating layers INS1 to INS5. A sixth insulating layer INS6 may be disposed on the fifth insulating layer INS5 and cover the first connection electrode CNE1.

The second connection electrode CNE2 may be disposed on the sixth insulating layer INS6. The second connection electrode CNE2 may be connected to the first connection electrode CNE1 through a second contact hole CE-3 defined in the sixth insulating layer INS6.

According to an embodiment, a second power line PL2 may be disposed on the sixth insulating layer INS6 and covered by a seventh insulating layer INS7 ("interlayer insulating layer" in the claims).

The seventh insulating layer INS7 may be disposed on the sixth insulating layer INS6 and cover the second connection electrode CNE2. The sixth and seventh insulating layers INS6 and INS7 may include one of an organic material and an inorganic material.

The lines P-1 to P-6 of the second power line PL2, described with reference to FIG. 5A, may be disposed on the sixth insulating layer INS6 and covered by the seventh insulating layer INS7.

The pixel defining layer PDL may be disposed on the seventh insulation layer INS7. An opening portion PDL-OP which exposes at least a portion of the first electrode AE-G1 may be defined in the pixel defining layer PDL. The opening portion PDL-OP may correspond to the emission area described above. In an embodiment, the pixel defining layer PDL may include an organic material having a light blocking property. According to an embodiment of the disclosure, the pixel defining layer PDL may have a color. In the display area DA (see FIG. 1A), the normal area A0 of the non-emission area NPXA may be defined as an area in which the pixel defining layer PDL is disposed, and the emission areas PDL may each be defined as an area overlapping the opening portion PDL-OP defined in the pixel defining layer PDL in a plan view.

The light emitting element OLED-G1 may include the first electrode AE-G1, the common layer CL-G1, and the second electrode CE. The first electrode AE-G1 may be disposed on the seventh insulating layer INS7 (interlayer insulating layer) and have a portion exposed by the opening portion PDL-OP.

The common layer CL-G1 included in the light emitting element OLED-G1 may be disposed on the first electrode AE-G1. The common layer CL-G1 may include a hole control layer, an electron control layer, an emission layer, and the like.

The second electrode CE may be disposed on the common layer CL-G1. The second electrode CE may be a single pattern disposed, in common, in the light emitting elements OLED. According to an embodiment, the second electrode CE may include a silver-magnesium alloy (AgMg).

As illustrated in FIG. 7, the partition wall WA may be disposed on a pixel defining layer PDL. For example, the partition wall WA may be entirely disposed on the pixel defining layer PDL in a non-emission area NPXA except for support areas A1.

The partition wall WA according to an embodiment may include a first insulating pattern IN1, a second insulating pattern IN2, a third insulating pattern IN3, a first partition wall pattern W1, and a second partition wall pattern W2.

The first insulating pattern IN1 may be directly disposed on the pixel defining layer PDL. The first insulating pattern IN1 may include an inorganic material. The second insulating pattern IN2 may be disposed on the first insulating pattern IN1. The third insulating pattern IN3 may be disposed on the second insulating pattern IN2. The first to third insulating patterns IN1, IN2 and IN3 may include different materials.

For example, the first insulating pattern IN1 may include at least one of indium zinc oxide, indium gallium zinc oxide, and indium tin oxide. The second insulating pattern IN2 and the third insulating pattern IN3 may include at least one of silicon oxide, silicon oxynitride, and silicon nitride.

In an embodiment, the first insulating pattern IN1 may be a component for disconnecting a p-type hole injection layer among layers included in a first common layer CL-G1. Thus, a thickness of the first insulating pattern IN1 may be greater than a thickness of the p-type hole injection layer among the layers included in the first common layer CL-G1.

According to an embodiment, in a cross-sectional view, a width of the second insulating pattern IN2 may be less than a width of each of the first insulating pattern IN1 and the third insulating pattern IN3. The difference in width may occur due to a difference in etch rate for an etchant between the first to third insulating pattern IN1, IN2 and IN3.

Common layers included in different pixels PX may be disconnected from each other by the first to third insulating pattern IN1, IN2 and IN3 with the partition wall WA disposed between pixels PX, and the disconnected common layers may be in contact with a side surface of each of the first to third insulating pattern IN1, IN2 and IN3 and a top surface of the third insulating pattern IN3.

The first partition wall pattern W1 may be disposed on the third insulating pattern IN3. The first partition wall pattern W1 may include a metal. For example, the first partition wall pattern W1 may include aluminum. As the first partition wall pattern W1 includes aluminum, a side surface W1-S of the first partition wall pattern W1 may be oxidized and thus have no conductivity. Thus, an inner side W1-I of the side surface W1-S of the first partition wall pattern W1 may be defined as a nonconductor area.

The second partition wall pattern W2 may be disposed on the first partition wall pattern W1. The second partition wall pattern W2 and the first partition wall pattern W1 may include different metals. For example, the second partition wall pattern W2 may include titanium.

According to an embodiment, a thickness of the first partition wall pattern W1 may be greater than a thickness of the second partition wall pattern W2, and a width of the first partition wall pattern W1 may be less than a width of the second partition wall pattern W2. According to an embodiment, a portion of the second partition wall pattern W2 may protrude from the first partition wall pattern W1 to be exposed from the first partition wall pattern W1. Thus, a bottom surface W2-B of the second partition wall pattern W2 may be exposed from the first partition wall pattern W1. This may occur due to a difference in etch rate for an etchant between the first partition wall pattern W1 and the second partition wall pattern W2. The first partition wall pattern W1 and the second partition wall pattern W2 may have a tip structure.

According to an embodiment of the disclosure, the partition wall WA disposed in the normal area A0 may be arranged to be spaced a certain space SS from a mask MS. Thus, the mask MS may be spaced apart from the partition wall WA in the normal area A0, and accordingly, a damage may not be applied in the process using the mask MS so that the tip structure of the partition wall WA disposed in the normal area A0 is stably maintained. The mask MS may be a fine metal mask used for a process of forming the common layer CL-G1 (see FIG. 6), before the forming of a second electrode CE.

The second electrode CE may extend from the emission areas PXA to the non-emission area NPXA and cover the partition wall WA. The second electrode CE overlapping the partition wall WA may be in contact with the side surface W1-S of the first partition wall pattern W1, the bottom surface W2-B of the second partition wall pattern W2 exposed from the first partition wall pattern W1, and a side surface W2-S of the second partition wall pattern W2.

According to an embodiment, a dummy pattern CL-P may be disposed on the partition wall WA. For example, the dummy pattern CL-P may be disposed between a top surface of the second partition wall pattern W2 and the second electrode CE. The dummy pattern CL-P may be a portion disconnected by the partition wall WA in a process of forming the common layers CL-G1 and CL-B.

As described above, the inner side W1-I of the first partition wall pattern W1 may include the nonconductor area oxidized and having no conductivity, and thus the second electrode CE which covers the partition wall WA may be connected to another portion of the second electrode CE through the bottom surface W2-B of the second partition wall pattern W2 exposed from the first partition wall pattern W1 and the side surface W2-S of the second partition wall pattern W2.

According to an embodiment, a first thickness of the second electrode CE disposed on the common layer CL-G1 may be greater than a second thickness of the second electrode CE which covers the partition wall WA. According to an embodiment, the second electrode CE may be in contact with only a portion of the side surface W1-S of the first partition wall pattern W1, and disconnected from another portion of the side surface W1-S of the first partition wall pattern W1. The remaining portion of the second electrode CE may be in contact with the side surface W2-S of the second partition wall pattern W2 and the dummy pattern CL-P. The second electrode CE disconnected on the partition wall WA may be in contact with the partition wall WA including a conductive material, and thus electrically connected by the partition wall WA.

The thin-film encapsulation layer TFE may be disposed on the light emitting element OLED-G1 and cover the light emitting element OLED-G1. The thin-film encapsulation layer TFE may be disposed in an entire area of the display area DA. The thin-film encapsulation layer TFE may include inorganic layers and an organic layer disposed between the inorganic layers, but embodiments of the disclosure are not limited thereto. A lower inorganic layer of the inorganic layers included in the thin-film encapsulation layer TFE may be directly disposed on the second electrode CE, and have a shape corresponding to a shape of the second electrode CE and cover the second electrode CE.

FIG. 8 is a schematic cross-sectional view taken along line II-II' in FIG. 5A. FIG. 9 is a schematic cross-sectional view taken along line III-III' in FIG. 5A.

Referring to FIG. 8, according to an embodiment, spacers SP may be disposed in support areas A1 of the non-emission area NPXA (see FIG. 6). The spacers SP may be disposed on a pixel defining layer PDL.

A partition wall WA may be disposed in a normal area A0 of the non-emission area NPXA, and the spacers SP may be respectively disposed in the support areas A1. The partition wall WA and the spacer SP may be directly disposed on the pixel defining layer PDL. The spacers SP according to an embodiment of the disclosure may be surrounded by the partition wall WA in a plan view, and spaced a certain distance from the partition wall WA. The partition wall WA and the spacer SP may be covered by the second electrode CE. An inorganic layer included in the thin-film encapsulation layer TFE described with reference to FIG. 6 may be disposed on the second electrode CE which covers the partition wall WA and the spacer SP.

According to an embodiment, at least one spacer SP may overlap a second power line PL2 in a plan view. FIG. 8 illustrates an embodiment overlapping a sixth line P-6 included in the second power line PL2.

The spacer SP may include a transparent organic material such as polyimide. According to an embodiment, the spacer SP and the pixel defining layer PDL may include a same material. For example, the spacer SP and the pixel defining layer PDL may each include a colored organic material having a light blocking property.

According to an embodiment of the disclosure, a surface area in which the spacers SP are disposed in the display area DA (see FIGS. 1A and 5) may be in a range of about 1% to about 10% of an entire surface area of the display area DA (see FIGS. 1A and 5).

According to an embodiment of the disclosure, a first thickness TH1 of the spacer SP may be greater than a second thickness TH2 of the partition wall WA. Accordingly, in a process using a mask MS, the partition wall WA may be spaced a certain space SS from the mask MS, and the mask MS may be supported by the spacer SP. A process for forming common layers CL-R and CL-B may be performed in a state in which the mask MS is supported by the spacer SP. Thus, when using the mask MS, the mask MS and the partition wall WA may be spaced from each other in the normal area A0, thereby more stably maintaining a tip structure of the partition wall WA.

Referring to FIG. 9, contact holes CNT which expose a second power line PL2 may be defined in contact areas A2. FIG. 9 schematically illustrates an embodiment in which a portion of a fourth line P-4 among the lines P-1 to P-6 (see FIG. 5) crossing the display area DA (see FIG. 5A) is exposed by the contact holes CNT.

According to an embodiment, the contact holes CNT may include a first hole C1 passing through a seventh insulating layer INS7, and a second hole C2 overlapping the first hole C1 and passing through a pixel defining layer PDL. A width of the second hole C2 may be greater than a width of the first hole C1.

A partition wall WA may be disposed inside the contact holes CNT in the contact areas A2, and thus a shape of the partition wall WA in the contact areas A2 may be different from the shape of the partition wall WA in the normal area A0. For convenience of explanation, the partition wall WA overlapping the contact areas A2 in a plan view will be described as a contact partition wall WA-C.

First to third insulating patterns IN1-C, IN2-C and IN3-C of the contact partition wall WA-C may cover a side surface of the pixel defining layer PDL, which defines the first hole C1, and a side surface of the seventh insulating layer IN7 which defines the second hole C2. First to third insulating patterns IN1-C, IN2-C and IN3-C together with the first hole C1 may expose the fourth line P-4, but embodiments of the disclosure are not limited thereto, and in another embodiment, the first insulating pattern IN1-C may be disposed on only the pixel defining layer PDL and spaced apart from the contact holes CNT.

A first partition wall pattern W1-C may be disposed on the third insulating pattern IN3-C and the fourth line P-4 and be in contact with the fourth line P-4. A second partition wall pattern W2-C may be disposed on the first partition wall pattern W1-C, and a second electrode CE may be disposed on the second partition wall pattern W2-C.

According to an embodiment of the disclosure, in a process using a mask MS, the contact partition wall WA-C may be arranged to be spaced a certain space SS from the mask MS. Thus, the contact partition wall WA-C may not be damaged in the process using the mask MS. Thus, a contact structure of the contact partition wall WA-C and the second power line PL2 may be stably maintained.

According to an embodiment of the disclosure, the second electrode CE may be connected to the second power line PL2, disposed in the display area DA (see FIG. 5A), through the partition wall WA in the display area DA (see FIG. 1A), thereby preventing a voltage drop to provide a constant voltage to pixels PX. As the connection between the second electrode CE and the second power line PL2 is achieved in the display area DA (see FIG. 5A), an unnecessary space for connecting the second electrode CE to the second power line PL2 may be reduced in a non-display area NDA. Moreover, pixel units having different resolutions may be individually driven.

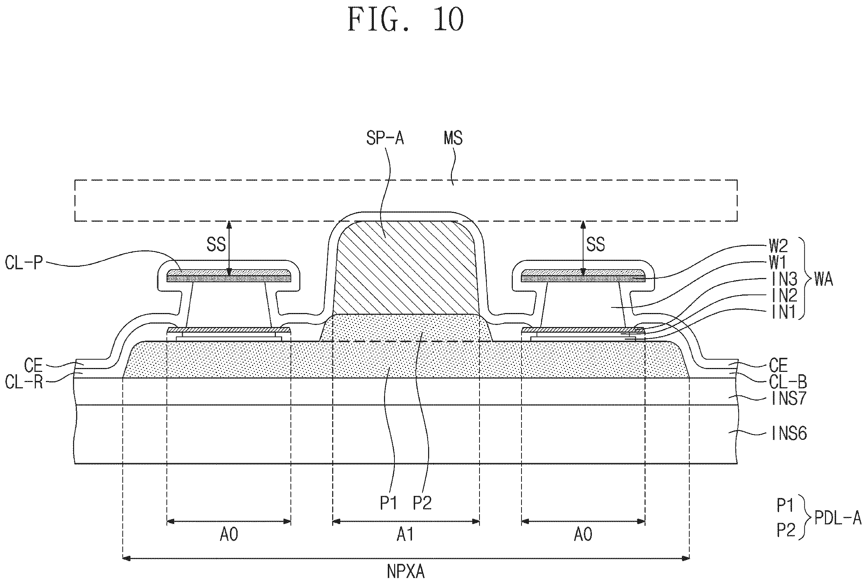

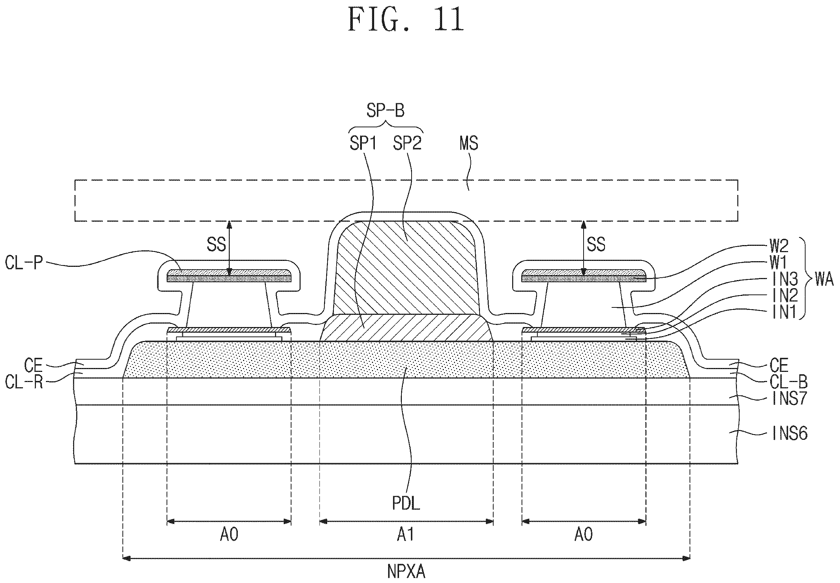

FIG. 10 is a schematic cross-sectional view of a support area of an electronic device according to an embodiment of the disclosure. FIG. 11 is a schematic cross-sectional view of a support area of an electronic device according to an embodiment of the disclosure. The same/similar components as/to those described with reference to FIGS. 6 to 9 are designated by the same/similar reference symbols, and redundant contents will be omitted.

Referring to FIG. 10, a pixel defining layer PDL-A according to an embodiment may be disposed on a seventh insulating layer INS7. According to an embodiment, in an area overlapping support areas A1 and an area adjacent to the support areas A1 in a plan view, the pixel defining layer PDL-A in an area overlapping spacers SP in a plan view may have a height greater than a height of the pixel defining layer PDL-A overlapping a partition wall WA in a plan view.

The pixel defining layer PDL-A according to an embodiment may include a first pattern P1 disposed in the entirety of a normal area A0 and the support areas A1, and a second pattern P2 disposed on the first pattern P1 and overlapping the spacers SP in a plan view. The first pattern P1 and the second pattern P2 may be formed through a half-tone exposure process.

Thus, each of spacers SP-A disposed on the second pattern P2 may have a height from the seventh insulating layer INS7, which is greater than a height of the partition wall WA. Thus, in a process using a mask MS, the mask MS may be in contact with only the spacers SPA so that the partition wall WA is not damaged.

Referring to FIG. 11, a spacer SP-B disposed in a support area A1 may have a structure in which multiple organic layers are stacked. For example, the spacer SP-B may include a first pattern SP1 and a second pattern SP2. The first pattern SP1 may be directly disposed on a pixel defining layer PDL. The second pattern SP2 may be directly disposed on the first pattern SP1. The first pattern SP1 and the second pattern SP2 may include one of a transparent organic material and a colored organic material having a light blocking property.

According to an embodiment, the spacer SP-B may include the organic layers and thus have a height greater than a height of a partition wall WA. Thus, a height from the pixel defining layer PDL to the spacer SP-B may be greater than the height of the partition wall WA. Thus, in a process using a mask MS, the mask MS may be in contact with only the spacers SP-B so that the partition wall WA is not damaged.

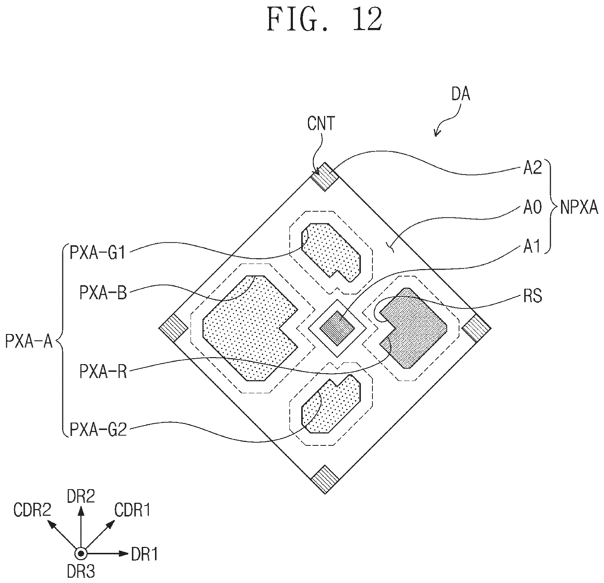

FIG. 12 is an enlarged plan view of a display area according to an embodiment of the disclosure. The same/similar components as/to those described with reference to FIGS. 5A to 9 are designated by the same/similar reference symbols, and redundant contents will be omitted.

Referring to FIG. 12, a pixel unit according to an embodiment may include an emission area PXA-A and a non-emission area NPXA. The emission area PXA-A may include (1-1)-th to third emission areas PXA-G1, PXA-G2, PXA-R and PXA-B, and the non-emission area NPXA may include a normal area A0, support areas A1, and contact areas A2 may be included. The contact areas A2 may be adjacent to corners of the emission areas PXA. The support areas A1 and the contact areas A2 may be spaced apart from each other. Each of the support areas A1 may be surrounded by the (1-1)-th to third emission areas PXA-G1, PXA-G2, PXA-R and PXA-B.

According to an embodiment, the (1-1)-th to third emission areas PXA-G1, PXA-G2, PXA-R and PXA-B may be changed in shape in order to increase a surface area of the spacer SP (see FIG. 8) disposed in each of the support areas A1. According to an embodiment, a recess area RS recessed inward from each of the emission areas PXA may be defined in a corner of each of the (1-1)-th to third emission areas PXA-G1, PXA-G2, PXA-R and PXA-B adjacent to the spacer SP. Dotted lines surrounding the (1-1)-th to third emission areas PXA-G1, PXA-G2, PXA-R and PXA-B may correspond to the first electrode AE (see FIG. 4B) of the light emitting element OLED-G1 (see FIG. 6).

According to an embodiment, the shapes of the (1-1)-th to third emission areas PXA-G1, PXA-G2, PXA-R and PXA-B may be changed in the display area DA, thereby securing a surface area in which the spacer SP is disposed.

As discussed, embodiments may provide an electronic device comprising: a substrate comprising a display area which comprises emission areas and a non-emission area, wherein the non-emission area comprises a normal area and support areas that are surrounded by the normal area, wherein the non-emission area is disposed between the emission areas; an interlayer insulating layer disposed on the substrate; a pixel defining layer which is disposed on the interlayer insulating layer and in which opening portions overlapping the emission areas in a plan view are defined; light emitting elements, each of which comprises a first electrode disposed on the interlayer insulating layer, wherein each light emitting element overlaps an opening portion in a plan view, wherein a common layer is disposed on the first electrode, and a second electrode is disposed on the common layer; a partition wall disposed on the pixel defining layer and overlapping the normal area in a plan view; and spacers disposed on the pixel defining layer and overlapping the support areas in a plan view, wherein each of the spacers is surrounded by a partition wall adjacent to each of the spacers in a plan view, and wherein each of the spacers is spaced apart from the adjacent partition wall.

The support areas may be surrounded by the normal area in a plan view. The support areas may be adjacent to the corners of the emission areas.

The normal area may be defined as an area in which a partition wall is disposed on a pixel defining layer.

The support areas may each be defined as an area in which a spacer is disposed. The spacer may be a structure which supports a mask.

The non-emission area may include the normal area, support areas, and contact areas. The support areas and the contact areas may be surrounded by the normal area in a plan view. The support areas and the contact areas may be adjacent to corners of the emission areas. The support areas and the contact areas may be spaced apart from each other. The contact areas may be defined as areas in which contact holes are defined in insulating layers and a contact partition wall are in contact with each other. A power line may be connected to a conductive pattern, included in the contact partition wall, through the contact holes.

The normal area may occupy most of the non-emission area, and the support area may be disposed so as to be surrounded by the normal area.

One support area may be surrounded by the emission areas included in the one pixel unit. For example, one pixel unit may include four emission areas. In such an example, the support area may occupy a central region of the pixel unit.

If present, the contact areas may be disposed outside the emission areas. For example, the contact areas may be respectively arranged to be adjacent to the outermost corners of the emission areas.

The spacers may be surrounded by the partition wall in a plan view, and spaced a certain distance from the partition wall. The partition wall and the spacer may be covered by the second electrode. An inorganic layer included in the thin-film encapsulation layer may be disposed on the second electrode which covers the partition wall and the spacer.

As mentioned, the emission areas may be arranged in pixel units. Each pixel unit may comprise a first-first emission area and a first-second emission area which provide light of a first color and are spaced apart from each other in a first direction; a second emission area which provides light of a second color different from the first color and is spaced apart from the first-first emission area and a first-second emission area in a diagonal direction; and a third emission area which is spaced apart from the second emission area in a second direction intersecting the first direction and provides light of a third color different from the first and second colors. The support area may occupy a central region of the pixel unit, so that the support area is in the middle of the arrangement of the emission areas in the pixel unit.

According to an embodiment the disclosure, the second electrode may be connected to the power line through the partition wall in the display area, and thus the voltage drop may be prevented to provide the constant voltage to the pixels. As the connection between the second electrode and the power line is achieved in the display area, the unnecessary space for connecting the second electrode to the second power line may be reduced in the non-display area.

Moreover, the spacer which supports the mask may be disposed in the display area, and thus the tip structure of the partition wall may be stably maintained even after the process using the mask.

The above description is an example of technical features of the disclosure, and those skilled in the art to which the disclosure pertains will be able to make various modifications and variations. Therefore, the embodiments of the disclosure described above may be implemented separately or in combination with each other.

Therefore, the embodiments disclosed in the disclosure are not intended to limit the disclosure, and the scope of the disclosure is not limited by these embodiments. The protection scope of the disclosure should be interpreted by the following claims, and it should be interpreted that all arrangements within the equivalent scope are included in the scope of the disclosure.

## Claims

1. An electronic device comprising:
a substrate comprising a display area which comprises emission areas and a non-emission area, wherein the non-emission area comprises a normal area and support areas that are surrounded by the normal area, wherein the non-emission area is disposed between the emission areas;
an interlayer insulating layer disposed on the substrate;
a pixel defining layer which is disposed on the interlayer insulating layer and in which opening portions overlapping the emission areas in a plan view are defined;
light emitting elements, each of which comprises a first electrode disposed on the interlayer insulating layer, wherein each light emitting element overlaps an opening portion in a plan view, wherein a common layer is disposed on the first electrode, and a second electrode is disposed on the common layer;
a partition wall disposed on the pixel defining layer and overlapping the normal area in a plan view; and
spacers disposed on the pixel defining layer and overlapping the support areas in a plan view,
wherein each of the spacers is surrounded by a partition wall adjacent to each of the spacers in a plan view, and wherein each of the spacers is spaced apart from the adjacent partition wall.

2. The electronic device of claim 1, wherein a height from the pixel defining layer to the spacers is greater than a height from the pixel defining layer to the partition wall.

3. The electronic device of claim 1 or 2, wherein the spacers comprise a transparent organic material or a colored organic material having a light blocking property.

4. The electronic device of any one of claims 1 to 3, wherein each of the spacers comprises a first pattern disposed on the pixel defining layer, and a second pattern disposed on the first pattern.

5. The electronic device of any one of claims 1 to 4, wherein, in an area adjacent to the support areas, a height of the pixel defining layer overlapping the spacers in a plan view is greater than a height of the pixel defining layer overlapping the partition wall in a plan view.

6. The electronic device of any one of claims 1 to 5, wherein a surface area in which the support areas are disposed in the display area is in a range of about 1% to about 10% of an entire surface area of the display area.

7. The electronic device of any one of claims 1 to 6, wherein the partition wall comprises a first insulating pattern disposed on the pixel defining layer, a second insulating pattern disposed on the first insulating pattern, a third insulating pattern disposed on the second insulating pattern, a first partition wall pattern disposed on the third insulating pattern, and a second partition wall pattern disposed on the first partition wall pattern.

8. The electronic device of claim 7, wherein the first to third insulating patterns comprise different materials, the first insulating pattern comprises at least one of indium zinc oxide, indium gallium zinc oxide, and indium tin oxide, and the second insulating pattern and the third insulating pattern comprise one of silicon oxide, silicon oxynitride, and silicon nitride; or
wherein the first partition wall pattern comprises aluminum, and the second partition wall pattern comprises titanium.

9. The electronic device of claim 7 or 8, wherein
a thickness of the first partition wall pattern is greater than a thickness of the second partition wall pattern,
a width of the second partition wall pattern is greater than a width of the first partition wall pattern, and
a portion of a bottom surface of the second partition wall pattern protrudes from the first partition wall pattern to be exposed from the first partition wall pattern and forms a tip portion.

10. The electronic device of claim 9, wherein
the second electrode is a single pattern that is provided, in common, to the light emitting elements, and
the second electrode extends from the emission areas to the non-emission area and covers a side surface of the first partition wall pattern and the portion of the bottom surface of the second partition wall pattern.

11. The electronic device of claim 10, further comprising:
a dummy pattern disposed between the second partition wall pattern and the second electrode, wherein the dummy pattern and the common layer comprise a same material;
optionally further comprising: power lines that provide power to the light emitting elements, wherein the power lines overlap the display area in a plan view, and wherein the power lines are disposed between the interlayer insulating layer and the substrate;
further optionally wherein: the non-emission area further comprises contact areas surrounded by the normal area in a plan view and spaced apart from the support areas, contact holes which pass through the interlayer insulating layer and the pixel defining layer and expose the power lines are defined in the contact areas, and the first partition wall pattern is in contact with the power lines exposed by the contact holes;
still further optionally wherein, in the contact areas, at least one of the first to third insulating patterns covers a side surface of the pixel defining layer and a side surface of the interlayer insulating layer, which define the contact holes.

12. The electronic device of any one of claims 1 to 11, wherein the pixel defining layer comprises a colored organic material having a light blocking property.

13. The electronic device of any one of claims 1 to 12, further comprising:
an encapsulation layer that covers the light emitting elements and is disposed on the pixel defining layer,
wherein the encapsulation layer comprises inorganic layers and an organic layer disposed between the inorganic layers.

14. The electronic device of any one of claims 1 to 13, wherein the emission areas comprise:
a first-first emission area and a first-second emission area which provide light of a first color and are spaced apart from each other in a first direction;
a second emission area which provides light of a second color different from the first color and is spaced apart from the first-first emission area and the first-second emission area in a diagonal direction; and
a third emission area which is spaced apart from the second emission area in a second direction intersecting the first direction and provides light of a third color different from the first and second colors.

15. The electronic device of claim 14, wherein each of the spacers is disposed between the first-first emission area, the first-second emission area, the second emission area, and the third emission area adjacent to each of the spacers; and/or
wherein the first-first emission area, the first-second emission area, the second emission area, and the third emission area have different shapes in a plan view.
